# EUROPEAN PATENT APPLICATION

(11) **EP 3 407 135 A1**
(43) Date of publication of application: **28.11.2018**
(21) Application number: 16886450.2
(22) Date of filing: 18.11.2016
(51) Int. Cl.: G03F 7/027, G03F 7/00, G03F 7/004, G03F 7/028, G03F 7/029

(54) **NEGATIVE LITHOGRAPHIC PRINTING ORIGINAL PLATE AND METHOD FOR PRODUCING LITHOGRAPHIC PRINTING PLATE**

(30) Priority: 22.01.2016 JP 2016010620
(71) Applicant: FUJIFILM Corporation, Tokyo 106-8620 (JP)
(72) Inventor: YASUHARA, Yuichi, Haibara-gun Shizuoka 421-0396 (JP); NOZAKI, Atsuyasu, Haibara-gun Shizuoka 421-0396 (JP)
(74) Representative: Hoffmann Eitle
(86) International application number: PCT/JP2016/084329
(87) International publication number: WO 2017/126211

(57) **Abstract**

A negative type lithographic printing plate precursor includes a support having a hydrophilic surface; and an image recording layer, on the support, containing a polymerization initiator and a polymer compound having a structure represented by Formula 1 in a main chain and an ethylenically unsaturated bond. Further, a method of preparing a lithographic printing plate includes, in order, an exposure step of image-exposing the negative type lithographic printing plate precursor; and a development step of performing development by removing a non-exposed portion of the exposed negative type lithographic printing plate precursor using a developer. In Formula 1, R¹ represents an (x + 2)-valent aromatic hydrocarbon ring group, and x represents an integer of 1 to 4.

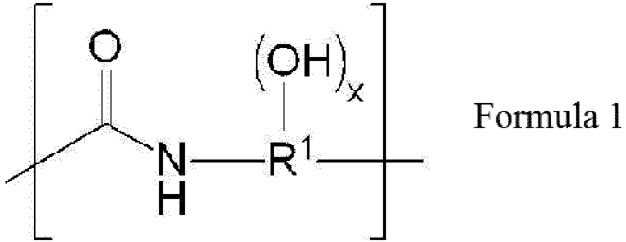

## Description

The present invention relates to a negative type lithographic printing plate precursor and a method of preparing a lithographic printing plate.

A computer to plate (CTP) technology for scanning a printing plate with light having high directivity, such as laser light, according to digitized image information and directly producing the printing plate has been desired. As such a lithographic printing plate precursor capable of scanning exposure, a lithographic printing plate precursor which includes a photopolymerization type image recording layer (also referred to as a photosensitive layer) which is provided on a hydrophilic support and contains a photopolymerization initiator; an addition-polymerizable ethylenically unsaturated compound; and a binder polymer that is soluble in a developer has been known. Such a lithographic printing plate precursor has advantages of excellent productivity and an easy development treatment.

As the photosensitive composition, those described in JP2008-233363A, JP2001-133975A, and JP2009-505157A have been known.

An object of embodiments of the present invention is to provide a negative type lithographic printing plate precursor having excellent printing durability, chemical resistance, and residual printing stain resistance of a lithographic printing plate to be obtained; and a method of preparing a lithographic printing plate obtained by using the negative type lithographic printing plate precursor.

The above-described object has been achieved by the means according to the following <1> or <15>. The following <1> or <15> is described below together with <2> to <14> which are preferred aspects.
<1> A negative type lithographic printing plate precursor comprising: a support having a hydrophilic surface; and an image recording layer, on the support, containing a polymerization initiator and a polymer compound having a structure represented by Formula 1 in a main chain and an ethylenically unsaturated bond. 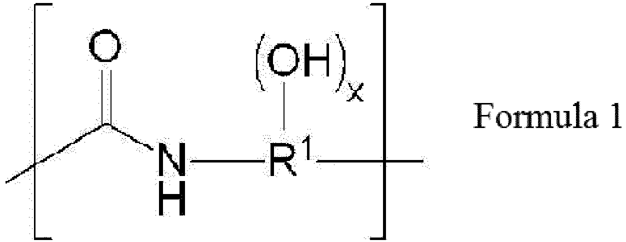
   In Formula 1, R¹ represents an (x + 2)-valent aromatic hydrocarbon ring group, and x represents an integer of 1 to 4.
<2> The negative type lithographic printing plate precursor according to <1>, in which the polymer compound is a polymer compound having a structure represented by Formula 2 in a main chain. 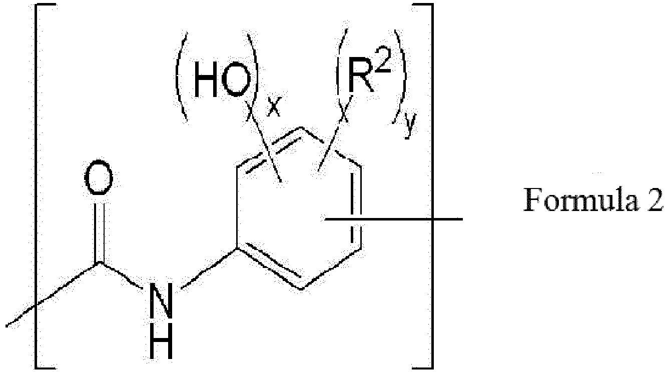
   In Formula 2, R²'s each independently represent an alkyl group or an aryl group, x represents an integer of 1 to 4, and y represents an integer of 0 to 3.
<3> The negative type lithographic printing plate precursor according to <1> or <2>, in which the polymer compound is a polymer compound having a structure represented by Formula 3. 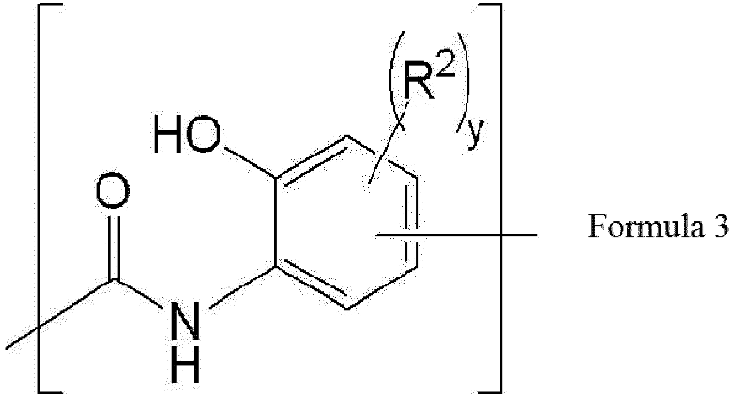
   In Formula 3, R²'s each independently represent an alkyl group or an aryl group, and y represents an integer of 0 to 3.
<4> The negative type lithographic printing plate precursor according to <1>, in which an amide bond in Formula 1 is not a part of a urea bond.
<5> The negative type lithographic printing plate precursor according to any one of <1> to <4>, in which the polymer compound is a resin having a constitutional repeating unit represented by Formula 4. 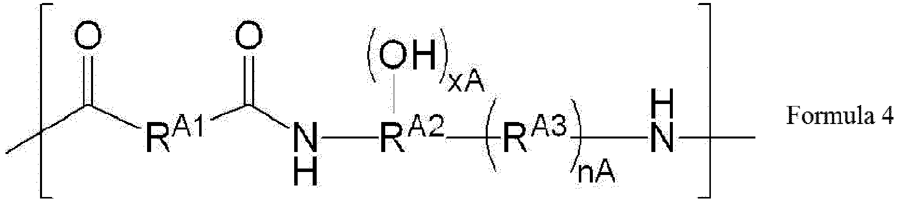
   In Formula 4, R^{A1} represents a divalent linking group, R^{A2} represents an (xA + 2)-valent aromatic hydrocarbon ring group, R^{A3} represents a divalent linking group, xA represents an integer of 1 to 4, and nA represents 0 or 1.
<6> The negative type lithographic printing plate precursor according to <5>, in which R^{A1} represents a divalent linking group bonded to two carbonyl groups in Formula 4 through a carbon atom.
<7> The negative type lithographic printing plate precursor according to any one of <1> to <6>, in which the image recording layer further contains a sensitizing dye having a maximum absorption wavelength of 700 to 1300 nm.
<8> The negative type lithographic printing plate precursor according to any one of <1> to <6>, in which the image recording layer further contains a sensitizing dye having a maximum absorption wavelength of 300 to 600 nm.
<9> The negative type lithographic printing plate precursor according to any one of <1> to <8>, in which the image recording layer further contains a polymerizable compound.
<10> The negative type lithographic printing plate precursor according to any one of <1> to <9>, in which the polymer compound is a polyamide resin.
<11> The negative type lithographic printing plate precursor according to any one of <1> to <10>, in which the polymerization initiator is a photo-radical polymerization initiator.
<12> The negative type lithographic printing plate precursor according to any one of <1> to <11>, in which the polymerization initiator is an onium salt compound.
<13> The negative type lithographic printing plate precursor according to any one of <1> to <12>, further comprising an undercoat layer between the support and the image recording layer.
<14> The negative type lithographic printing plate precursor according to any one of <1> to <13>, further comprising a protective layer on the image recording layer.
<15> A method of preparing a lithographic printing plate, comprising, in order: an exposure step of image-exposing the negative type lithographic printing plate precursor according to any one of <1> to <14>; and a development step of performing development by removing a non-exposed portion of the exposed negative type lithographic printing plate precursor using a developer.

According to the aspects of the present invention, it is possible to provide a negative type lithographic printing plate precursor having excellent printing durability, chemical resistance, and residual printing stain resistance of a lithographic printing plate to be obtained; and a method of preparing a lithographic printing plate obtained by using the negative type lithographic printing plate precursor.

Hereinafter, the content of the present disclosure will be described in detail. The description of constituent elements below will be made based on representative embodiments of the present disclosure, but the present disclosure is not limited to such embodiments.

In the present specification, in a case where numerical ranges are shown using "to", the numerical ranges indicate ranges including the numerical values described before and after "to" as the lower limits and the upper limits.

In a case where groups (atomic groups) are noted without mentioning substitution and unsubstitution in the notation of compounds in the present specification, the concept thereof includes unsubstituted groups and groups having substituents. For example, the concept of an "alkyl group" includes not only an alkyl group (unsubstituted alkyl group) which does not have a substituent but also an alkyl group (substituted alkyl group) which has a substituent.

Further, the chemical structural formulae in the present specification may be simplified structural formulae by omitting hydrogen atoms.

Further, in the present specification, "(meth)acrylate" indicates acrylate and methacrylate; "(meth)acryl" indicates acryl and methacryl; and "(meth)acryloyl" indicates acryloyl and methacryloyl.

Further, in the present disclosure, "% by mass" has the same definition as that for "% by weight"; and "part by mass" has the same definition as that for "parts by weight".

In the present disclosure, a combination of two or more preferred aspects is a more preferred aspect.

### (Negative type lithographic printing plate precursor)

A negative type lithographic printing plate precursor (hereinafter, also simply referred to as a "lithographic printing plate precursor") of the present disclosure includes a support having a hydrophilic surface; and an image recording layer, on the support, containing a polymerization initiator and a polymer compound (hereinafter, also referred to as a "specific polymer compound") having a structure represented by Formula 1 in a main chain and an ethylenically unsaturated bond.

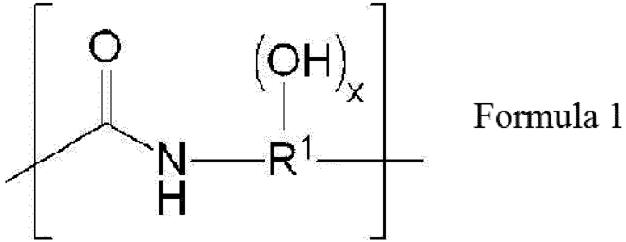

In Formula 1, R¹ represents an (x + 2)-valent aromatic hydrocarbon ring group, and x represents an integer of 1 to 4.

As a result of intensive research conducted by the present inventors, the present inventors found that, in a case where the image recording layer contains a polymerization initiator and a polymer compound having a structure represented by Formula 1 in the main chain and an ethylenically unsaturated bond, a negative type lithographic printing plate precursor having excellent printing durability, chemical resistance, and residual printing stain resistance is obtained.

Although the action mechanism in the present disclosure is not clear, it is estimated as follows.

Based on the research conducted by the present inventors, it is estimated that, since the specific polymer compound of the present disclosure has an amide structure in which an interaction between polymer compounds is high, an interaction between polymer compounds is high, aggregating properties are remarkably improved, the resistance to chemicals (cleaners or organic compounds) used for printing is extremely high, the strength of an image area is excellent, and the printing durability becomes excellent. Further, it is estimated that the printing durability becomes excellent because the specific polymer compound has a plurality of amide bonds with an extremely high interaction and excellent aggregating properties.

Further, the details of the mechanism for improvement in residual printing stain resistance are not clear, but it is estimated that, since the specific polymer compound in the present disclosure has a structure with a high hydrophilicity, which is represented by Formula 1, in the main chain and an ethylenically unsaturated bond, the effects can be obtained by polymerizing this compound.

Hereinafter, the negative type lithographic printing plate precursor of the present disclosure will be described in detail.

### <Image recording layer>

The negative type lithographic printing plate precursor of the present disclosure includes an image recording layer which contains a polymerization initiator and a polymer compound having a structure represented by Formula 1 in the main chain and an ethylenically unsaturated bond. The image recording layer is a negative type image recording layer.

### - Specific polymer compound -

The image recording layer contains a polymer compound (specific polymer compound) having a structure represented by Formula 1 in the main chain and an ethylenically unsaturated bond.

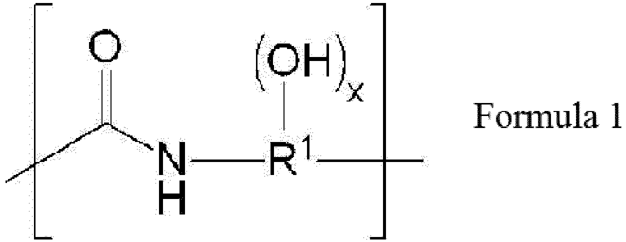

In Formula 1, R¹ represents an (x + 2)-valent aromatic hydrocarbon ring group, and x represents an integer of 1 to 4.

It is preferable that x hydroxy groups in Formula 1 are respectively a group directly bonded to an aromatic hydrocarbon ring, that is, a phenolic hydroxy group.

In Formula 1, x represents preferably 1 or 2 and more preferably 1. According to the above-described aspect, a lithographic printing plate having excellent printing durability and chemical resistance can be obtained and alkali aqueous solution developability is further improved.

It is preferable that the (x + 2)-valent aromatic hydrocarbon ring group as R¹ in Formula 1 is a group obtained by removing (x + 2) hydrogen atoms from an aromatic hydrocarbon ring.

The aromatic hydrocarbon ring is not particularly limited, but a benzene ring or a naphthalene ring is preferable and a benzene ring is more preferable.

Further, the aromatic hydrocarbon ring may have a substituent on an aromatic ring.

Examples of the substituent include an alkyl group, an aryl group, a halogen atom, an alkoxy group, an alkoxycarbonyl group, and an acyl group. Further, the substituent may be further substituted with a substituent, or two or more substituents may be bonded to one another to form a ring. In addition, the number of carbon atoms in the substituent is preferably in a range of 0 to 20, more preferably in a range of 0 to 12, and still more preferably in a range of 0 to 8.

It is preferable that the amide bond in Formula 1 is not a part of a urea bond and more preferable that the amide bond in Formula 1 is not a part of a urea bond or a urethane bond.

The specific polymer compound may have only one or two or more kinds of structures represented by Formula 1.

Further, it is preferable that the specific polymer compound is a polymer compound having a structure represented by Formula 2. According to the above-described aspect, a lithographic printing plate having excellent printing durability and chemical resistance can be obtained and alkali aqueous solution developability is further improved.

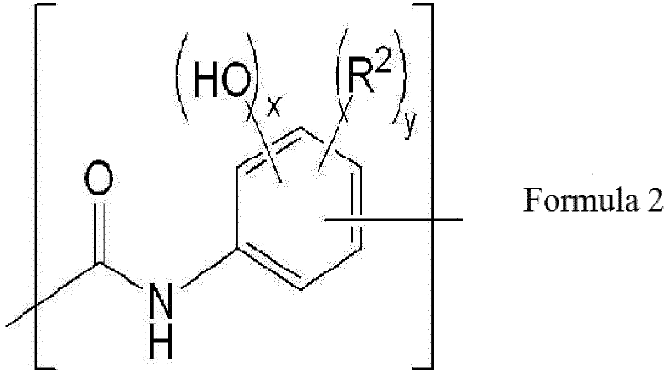

In Formula 2, R²'s each independently represent an alkyl group or an aryl group, x represents an integer of 1 to 4, and y represents an integer of 0 to 3.

In Formula 2, x represents preferably 1 or 2 and more preferably 1. According to the above-described aspect, a lithographic printing plate having excellent printing durability and chemical resistance can be obtained and alkali aqueous solution developability is further improved.

In Formula 2, y represents preferably 0 or 1 and more preferably 0.

It is preferable that R² in Formula 2 represents an alkyl group having 1 to 8 carbon atoms or an aryl group having 6 to 12 carbon atoms.

Further, the bonding position, on the benzene ring of Formula 2, with another structure other than the structure in Formula 2 is not particularly limited, and the position may be an o-position, an m-position, or a p-position of an amide group, but an m-position or a p-position is preferable and a p-position is more preferable.

It is preferable that the amide bond in Formula 2 is not a part of a urea bond and more preferable that the amide bond in Formula 2 is not a part of a urea bond or a urethane bond.

Further, it is more preferable that the specific polymer compound is a polymer compound having a structure represented by Formula 3. According to the above-described aspect, the amide group and the hydroxy group in Formula 3 can be subjected to dehydration condensation and cyclized to form a benzoxazole ring. Since the cyclization occurs due to heat from post-baking or the like after development so that a benzoxazole ring is formed, a lithographic printing plate with excellent printing durability and chemical resistance can be obtained.

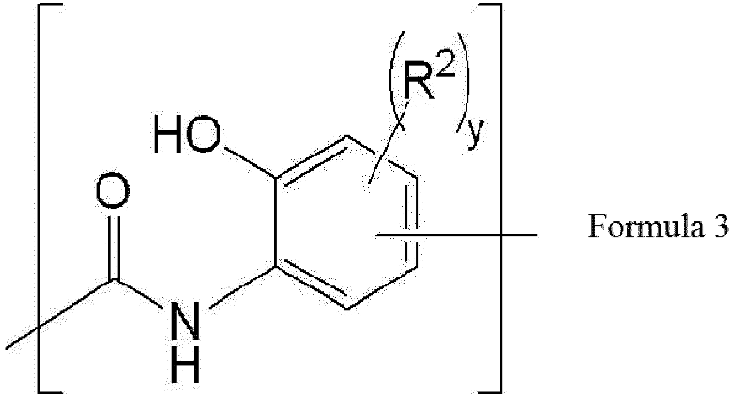

In Formula 3, R²'s each independently represent an alkyl group or an aryl group, and y represents an integer of 0 to 3.

In Formula 3, y represents preferably 0 or 1 and more preferably 0.

It is preferable that R² in Formula 3 represents an alkyl group having 1 to 8 carbon atoms or an aryl group having 6 to 12 carbon atoms.

Further, the bonding position, on the benzene ring of Formula 3, with another structure other than the structure in Formula 3 is not particularly limited, but it is preferable that the position is a p-position of an amide group or a p-position of a hydroxy group.

It is preferable that the amide bond in Formula 3 is not a part of a urea bond and more preferable that the amide bond in Formula 3 is not a part of a urea bond or a urethane bond.

Further, the specific polymer compound is preferably a polyamide resin, more preferably a linear polyamide resin, and still more preferably a resin obtained by polycondensing a bifunctional amino compound and a bifunctional carboxy compound or an equivalent thereof.

Preferred examples of the equivalent of the carboxy compound include a carboxylic acid halide compound and a carboxylic acid ester compound.

Among these, from the viewpoints of the reaction activity and the reaction rate, it is particularly preferable that the specific polymer compound is a resin obtained by polycondensing a bifunctional amino compound and a bifunctional carboxylic acid halide compound.

In the present disclosure, the "main chain" indicates the relatively longest bonding chain in a molecule of a polymer compound constituting a resin and the "side chain" indicates a carbon chain branched from the main chain.

Further, it is preferable that the specific polymer compound is a resin having an alkyleneoxy group in the main chain. According to the above-described aspect, it is possible to obtain a photosensitive resin composition from which a lithographic printing plate having excellent image formability and printing durability is obtained.

As the alkyleneoxy group, an alkyleneoxy group having 2 to 10 carbon atoms is preferable; an alkyleneoxy group having 2 to 8 carbon atoms is more preferable; an alkyleneoxy group having 2 to 4 carbon atoms is still more preferable; and an ethyleneoxy group, a propyleneoxy group, or an isopropyleneoxy group is particularly preferable.

Further, the alkyleneoxy group may be a polyalkyleneoxy group.

As the polyalkyleneoxy group, a polyalkyleneoxy group having a repetition number of 2 to 50 is preferable; a polyalkyleneoxy group having a repetition number of 2 to 40 is more preferable; and a polyalkyleneoxy group having a repetition number of 2 to 30 is still more preferable.

The preferable number of carbon atoms in a constitutional repeating unit of the polyalkyleneoxy group is the same as the preferable number of carbon atoms in the alkyleneoxy group.

As a structure to which a phenolic hydroxy group is bonded, it is preferable that the specific polymer compound has a benzene structure, a diphenylmethane structure, a diphenylsulfone structure, a benzophenone structure, a biphenyl structure, a naphthalene structure, an anthracene structure, or a terphenyl structure; more preferable that the specific polymer compound has a diphenylmethane structure, a diphenylsulfone structure, a benzophenone structure, or a biphenyl structure; and still more preferable that the specific polymer compound has a diphenylmethane structure or a biphenyl structure.

Further, as the specific polymer compound, a resin having a constitutional repeating unit represented by Formula 4 is preferable; a polyamide resin having a constitutional repeating unit represented by Formula 4 is more preferable; a polyamide resin having 20% by mass or greater of a constitutional repeating unit represented by Formula 4 is still more preferable; and a polyamide resin having 50% by mass of a constitutional repeating unit represented by Formula 4 is particularly preferable.

Further, the terminal structure of the specific polymer compound depends on a quenching agent used in a case where the polycondensation reaction is stopped, and examples thereof include a hydrogen atom, a hydroxy group, a carboxyl group, an amino group, and/or an alkoxy group.

Further, the specific polymer compound may have only one or two or more constitutional repeating units represented by Formula 4.

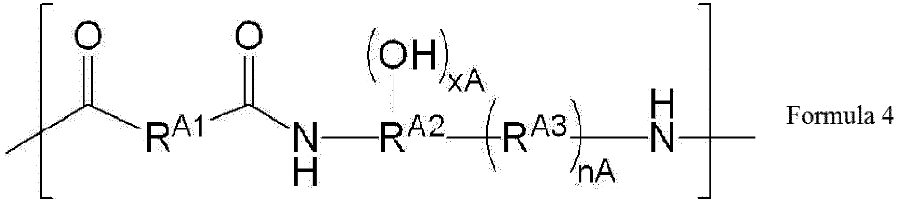

In Formula 4, R^{A1} represents a divalent linking group, R^{A2} represents an (xA + 2)-valent aromatic hydrocarbon ring group, R^{A3} represents a divalent linking group, xA represents an integer of 1 to 4, and nA represents 0 or 1.

Further, R^{A2} in Formula 4 and xA hydroxy groups and amide bonds bonded to R^{A2} correspond to the structure represented by Formula 1.

R^{A2} and xA in Formula 4 respectively have the same definitions as those for R¹ and x in Formula 1 and the preferable aspects thereof are respectively the same as described above.

It is preferable that the amide bond in Formula 4 is not a part of a urea bond and more preferable that the amide bond in Formula 1 is not a part of a urea bond or a urethane bond.

As R^{A1} in Formula 4, a divalent linking group bonded to two carbonyl groups in Formula 4 through a carbon atom is preferable; an alkylene group, a cycloalkylene group, an arylene group, or a group formed by bonding two or more of these groups is more preferable; an alkylene group, a cycloalkylene group, an arylene group, or a biphenylene group is still more preferable; an alkylene group or a phenylene group is still more preferable; and an alkylene group is particularly preferable.

The alkylene group, the cycloalkylene group, the arylene group, and the group formed by bonding two or more of these groups described above may have a substituent, but it is preferable that these groups do not have a substituent.

Examples of the substituent include an alkyl group, an aryl group, a halogen atom, an alkoxy group, an alkoxycarbonyl group, and an acyl group. In addition, the substituent may be further substituted with another substituent or two or more substituents may be bonded to one another to form a ring. Further, the number of carbon atoms in the substituent is preferably in a range of 0 to 20, more preferably in a range of 0 to 12, and still more preferably in a range of 0 to 8.

The number of carbon atoms in the group as R^{A1} is preferably in a range of 1 to 30 and more preferably in a range of 3 to 20.

It is preferable that nA in Formula 4 represents 1.

As R^{A3} in Formula 4, an alkylene group, a cycloalkylene group, an aromatic hydrocarbon ring group, or a group formed by bonding a group selected from the group consisting of an alkylene group, a cycloalkylene group, an aromatic hydrocarbon ring group, a carbonyl group, a sulfonyl group, and a fluorenyl group to an aromatic hydrocarbon ring group is preferable; and an aromatic hydrocarbon ring group or a group formed by bonding a group selected from the group consisting of a methylene group, a 2,2-propanediyl group, a bistrifluoromethylmethylene group, a sulfonyl group, and a fluorenyl group to an aromatic hydrocarbon ring group is more preferable.

The alkylene group, the cycloalkylene group, the aromatic hydrocarbon ring group, or the group formed by bonding a group selected from the group consisting of an alkylene group, a cycloalkylene group, an aromatic hydrocarbon ring group, a carbonyl group, a sulfonyl group, and a fluorenyl group to an aromatic hydrocarbon ring group may have a substituent, but it is preferable that these groups do not have a substituent.

Examples of the substituent include an alkyl group, an aryl group, a halogen atom, an alkoxy group, an alkoxycarbonyl group, and an acyl group. In addition, the substituent may be further substituted with another substituent or two or more substituents may be bonded to one another to form a ring. Further, the number of carbon atoms in the substituent is preferably in a range of 0 to 20, more preferably in a range of 0 to 12, and still more preferably in a range of 0 to 8.

As the aromatic hydrocarbon ring group as R^{A3}, an aromatic hydrocarbon ring group having a hydroxy group is preferable; an aromatic hydrocarbon ring group having 1 to 4 hydroxy groups is more preferable; and an aromatic hydrocarbon ring group having one hydroxy group is particularly preferable.

Further, the constitutional repeating unit represented by Formula 4 is preferably a constitutional repeating unit represented by any one of Formulae 4-1 to 4-6 and more preferably a constitutional repeating unit represented by Formula 4-1 or 4-3.

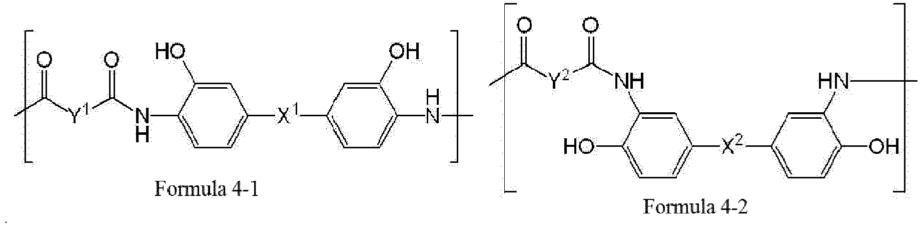

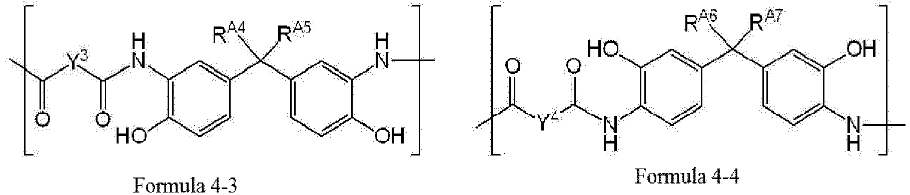

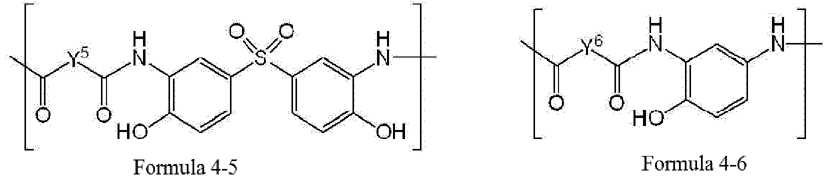

In Formulae 4-1 to 4-6, Y¹ to Y⁶ each independently represent a divalent linking group, X¹ and X² each independently represent a single bond, an alkylene group, or a carbonyl group, and R^{A4} to R^{A7} each independently represent a hydrogen atom or an alkyl group.

Y¹ to Y⁶ in Formulae 4-1 to 4-6 have the same definitions as those for R^{A1} in Formula 4 and the preferable aspects thereof are the same as described above.

X¹ and X² in Formulae 4-1 to 4-6 each independently represent preferably a single bond, a methylene group, or a carbonyl group and more preferably a single bond.

The alkyl group as R^{A4} to R^{A7} may have a substituent.

Examples of the substituent include a halogen atom, an alkyl group, and an aryl group. Among these, a halogen atom is preferable and a fluorine atom is more preferable.

R^{A4} to R^{A7} in Formulae 4-1 to 4-6 each independently represent preferably a hydrogen atom, a methyl group, or a trifluoromethyl group and more preferably a methyl group or a trifluoromethyl group.

Further, it is preferable that R^{A4} and R^{A5} represent the same group and R^{A6} and R^{A7} represent the same group.

The content of the constitutional repeating unit, represented by any of Formulae 4-1 to 4-6, in the specific polymer compound is preferably in a range of 10% to 95% by mass, more preferably in a range of 10% to 95% by mass, still more preferably in a range of 30% to 90% by mass, and particularly preferably in a range of 50% to 90% by mass with respect to the total mass of the specific polymer compound.

Further, it is preferable that the structure represented by Formula 1 in the specific polymer compound used in the present disclosure is a structure obtained by reacting the following diamine compound with a diacid halide compound.

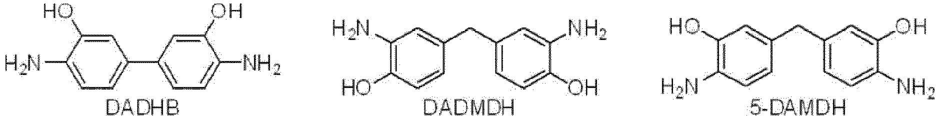

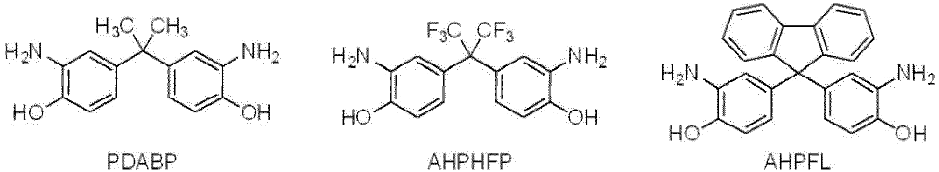

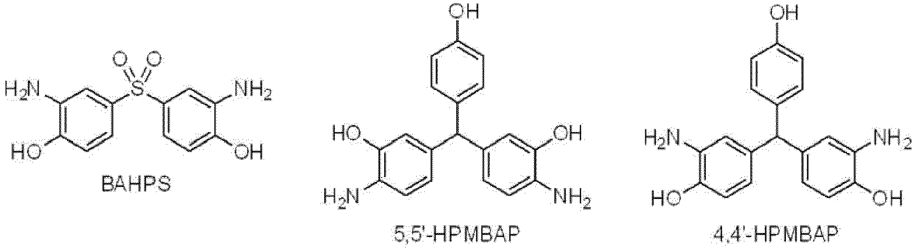

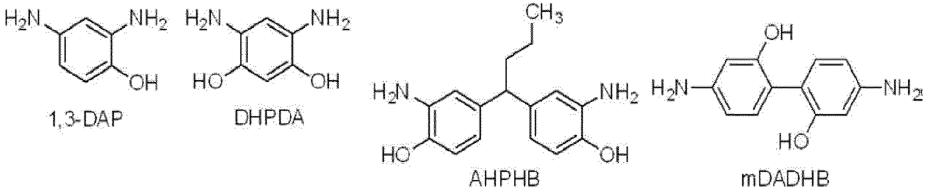

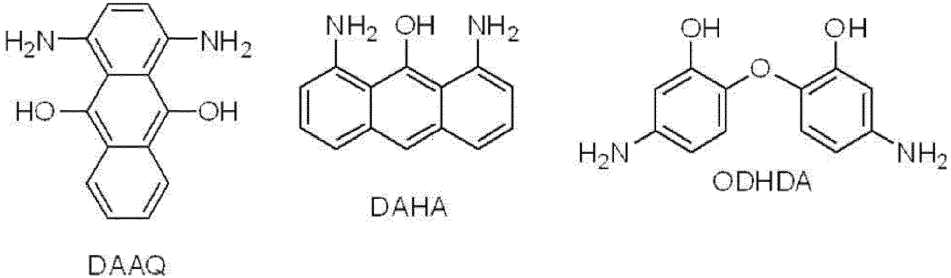

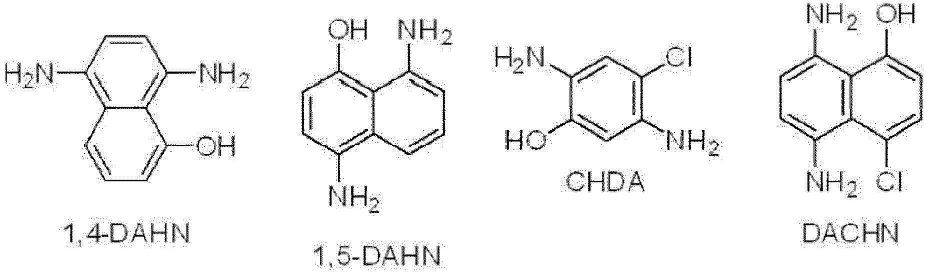

Among examples of the diamine compound, it is preferable to use DADHB, 1,3-DAP, 5-DAMDH, PDABP, AHPHFP, or AHPFL, more preferable to use DADHB or PDABP, and particularly preferable to use DADHB.

It is preferable that the specific polymer compound used in the present disclosure is a polyamide resin obtained by at least reacting a diamine compound with the following diacid halide compound.

In addition, as the diacid halide compound, a dicarboxylic acid halide compound is preferably exemplified and a dicarboxylic acid chloride compound is more preferably exemplified.

Further, as the diacid halide compound, an aliphatic diacid halide compound is preferably exemplified.

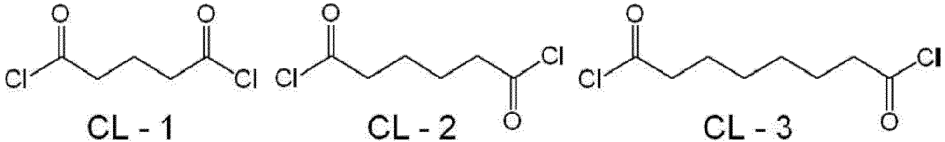

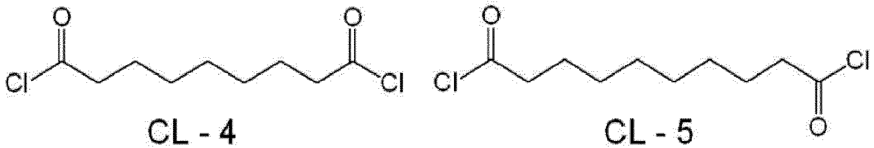

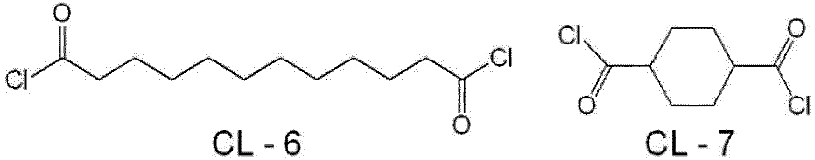

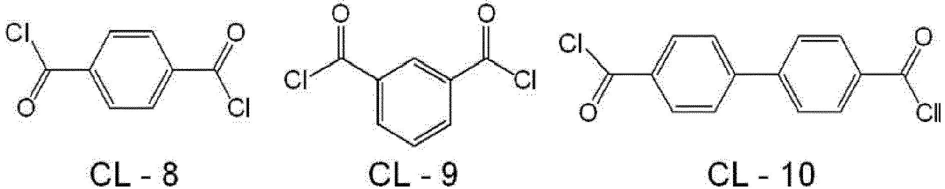

Among the examples of the diacid halide compound, it is preferable to use a compound selected from the group consisting of CL-2 to CL-6, CL-9, and CL-10, more preferable to use a compound selected from the group consisting of CL-2, CL-5, and CL-9, and particularly preferable to use CL-2 or CL-5.

### [Ethylenically unsaturated bond]

The specific polymer compound used in the present disclosure has an ethylenically unsaturated bond, and it is preferable that the specific polymer compound has a constitutional unit having an ethylenically unsaturated bond.

The specific polymer compound may have the ethylenically unsaturated bond in the main chain or in a side chain thereof, but it is preferable that the specific polymer compound has the ethylenically unsaturated bond in a side chain thereof.

The ethylenically unsaturated bond in the specific polymer compound is not particularly limited, but a group selected from the group consisting of an acryloyl group, a methacryloyl group, and an allyl group is preferable and a group selected from the group consisting of an acryloyl group and a methacryloyl group is more preferable.

A method of introducing the ethylenically unsaturated bond into the specific polymer compound is not particularly limited, and examples thereof include a method of using a polycondensable monomer that contains an ethylenically unsaturated group, a method of obtaining an ethylenically unsaturated group from a precursor group of an ethylenically unsaturated group after polymerization using a monomer having a precursor group of an ethylenically unsaturated group, and a method of introducing an ethylenically unsaturated group by performing a polymer reaction.

Among these, as the method of introducing the ethylenically unsaturated bond into the specific polymer compound, a method of using a diamine compound that contains an ethylenically unsaturated group in a side chain as a raw material is suitably exemplified.

Preferred examples of the constitutional unit having an ethylenically unsaturated bond include constitutional units represented by Formulae 5-1 to 5-3.

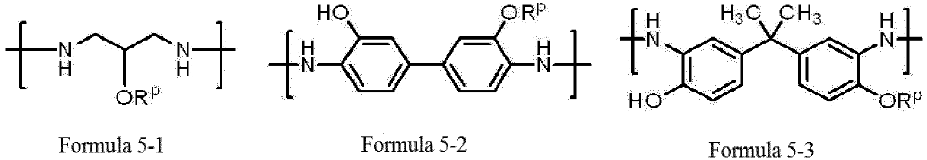

In Formulae 5-1 to 5-3, R^{P}'s each independently represent a group having an ethylenically unsaturated bond.

Preferred examples of the group having an ethylenically unsaturated bond as R^{P} include an acrylic group, a methacrylic group, an allyl group, and a group formed by bonding these ethylenically unsaturated groups through a linking group.

As the linking group, a group having 2 to 40 carbon atoms is preferably exemplified.

Further, as the linking group, an alkylene group or a group to which one or more groups, selected from the group consisting of one or more alkylene groups, an ether bond, a carbonyl group, an amide group, and a urethane bond, are linked is preferably exemplified.

Preferred specific examples of the constitutional unit having an ethylenically unsaturated group in the specific polymer compound will be shown below, but examples thereof are not limited thereto.

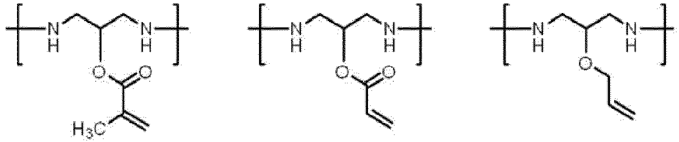

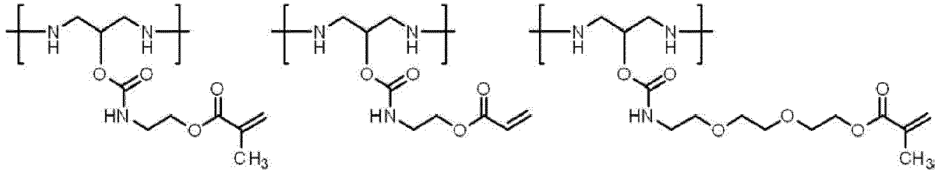

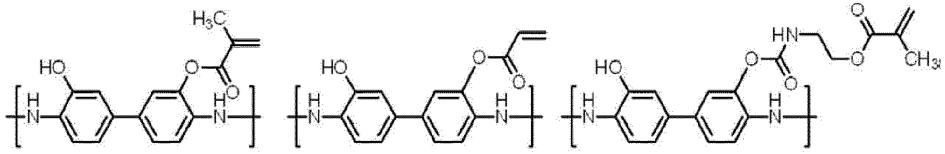

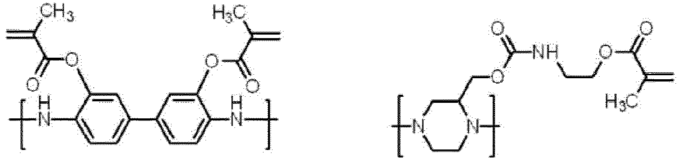

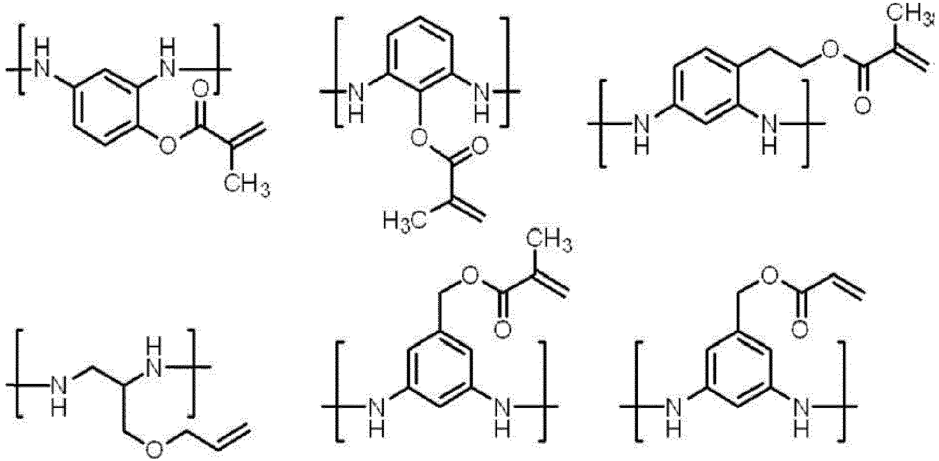

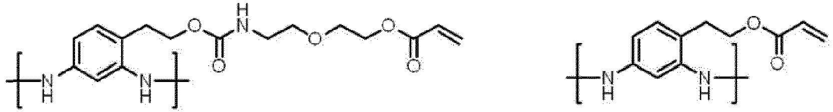

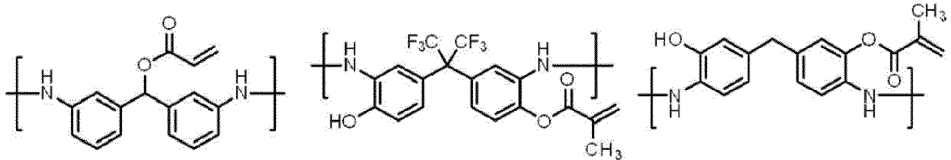

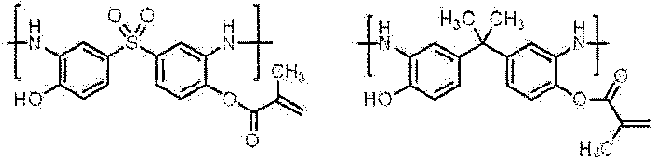

The molar ratio between the amide bond and the ethylenically unsaturated group (amide bond:ethylenically unsaturated group) contained in the specific polymer compound is preferably in a range of 50:1 to 1:1, more preferably in a range of 30:1 to 2:1, and still more preferably in a range of 20:1 to 3:1. In a case where the molar ratio is in the above-described range, a lithographic printing plate having excellent chemical resistance can be obtained.

### [Other constitutional units]

The specific polymer compound used in the present disclosure may have other constitutional units in addition to the structure represented by Formula 1, the constitutional unit having an ethylenically unsaturated group, and the constitutional unit derived from a diacid halide compound.

Further, examples of the diamine compound which is suitably obtained in order to form other constitutional units in the specific polymer compound are shown below.

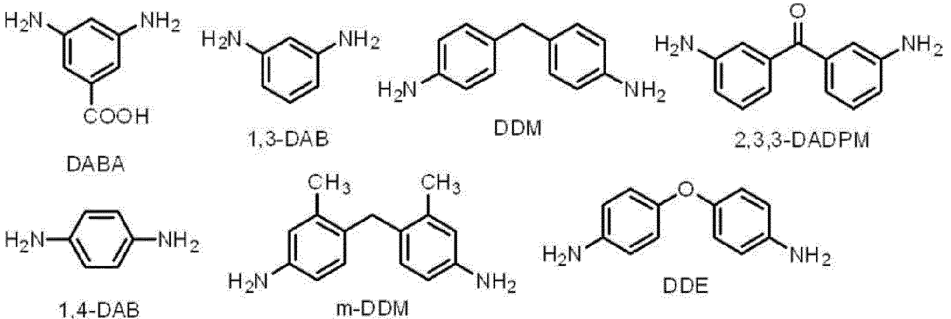

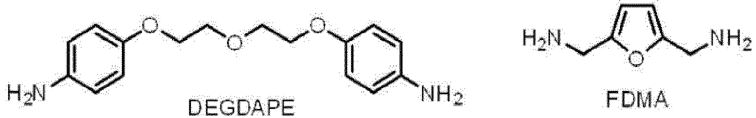

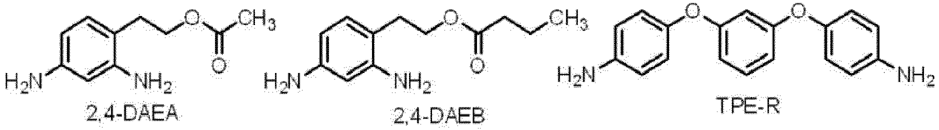

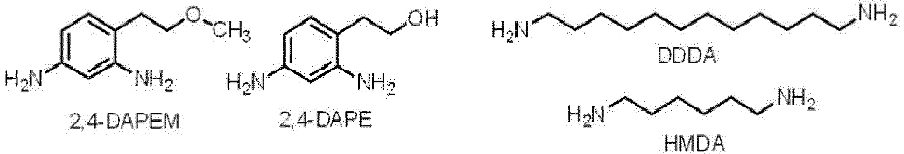

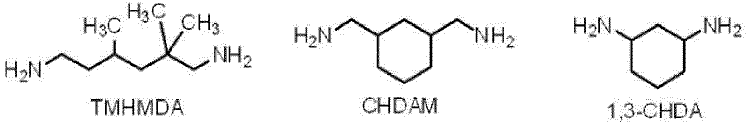

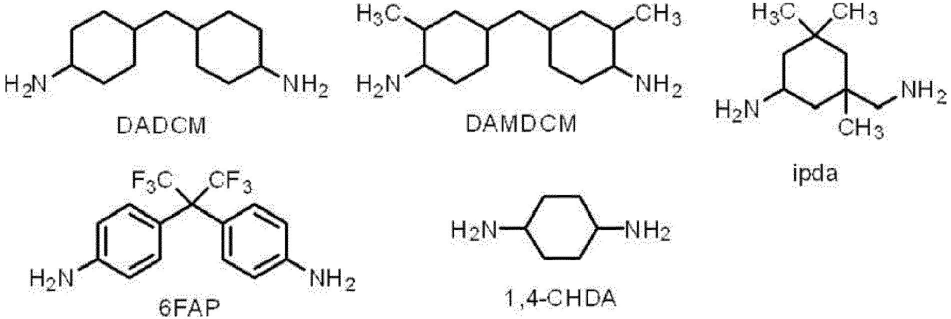

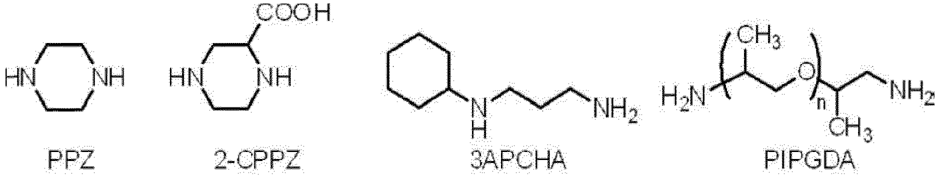

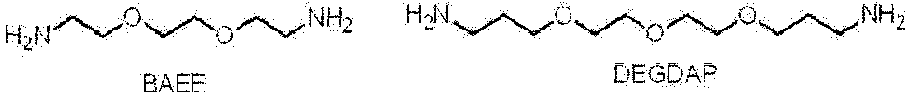

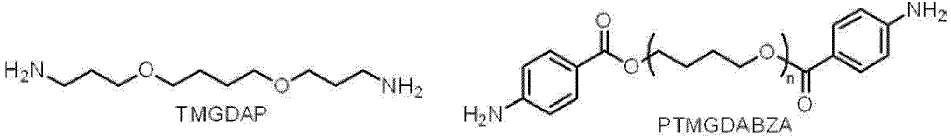

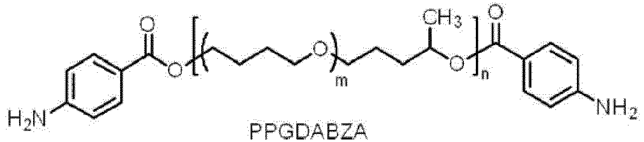

In addition, m and n each independently represent an integer of 1 to 100.

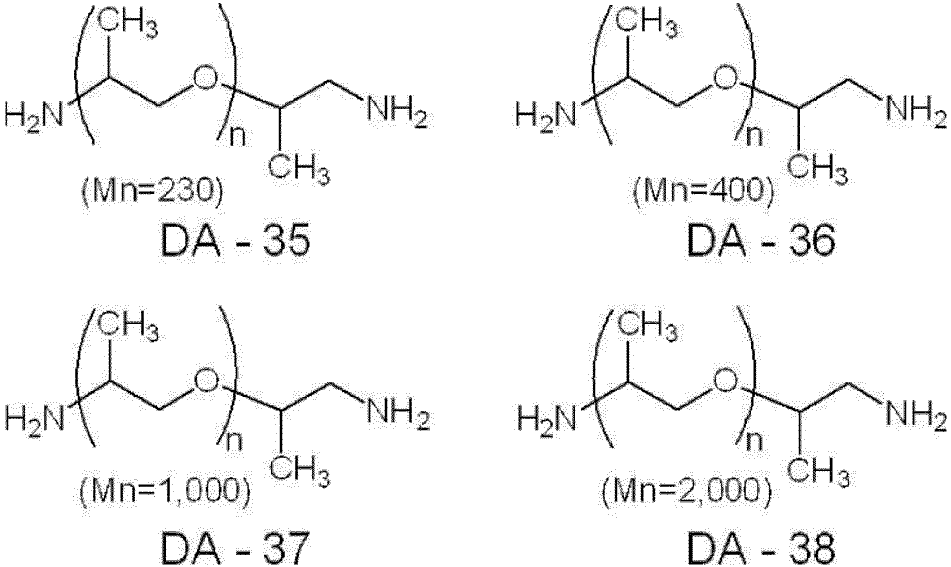

Preferred specific examples of the specific polymer compound used in the present disclosure will be described below, but the present invention is not limited thereto. Further, the numerical values at the lower right of parentheses showing constitutional units indicate molar ratios. Moreover, the weight-average molecular weight (Mw) of an exemplary compound is a value measured according to a GPC method described below.

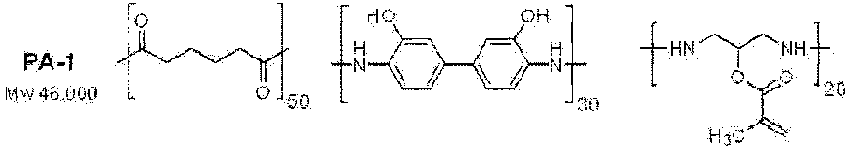

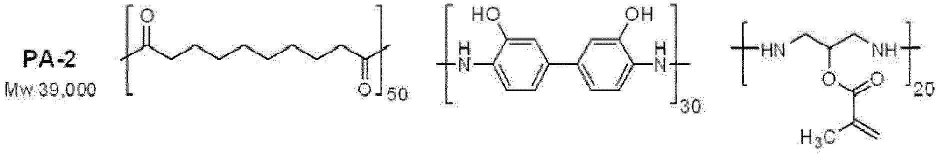

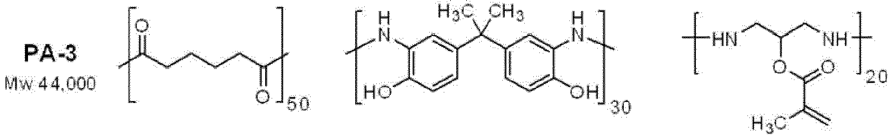

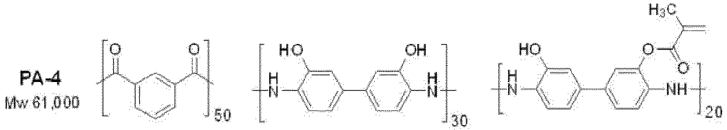

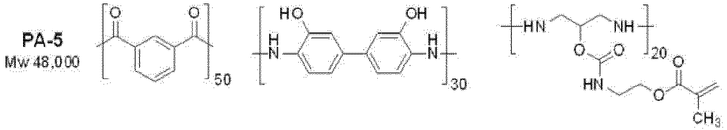

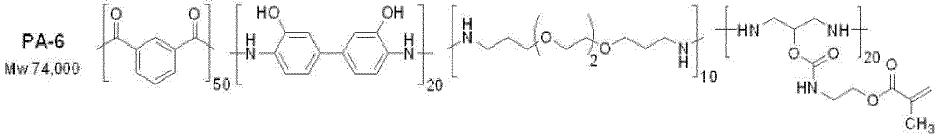

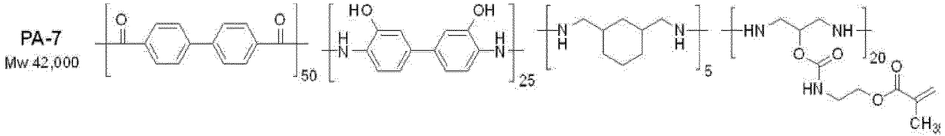

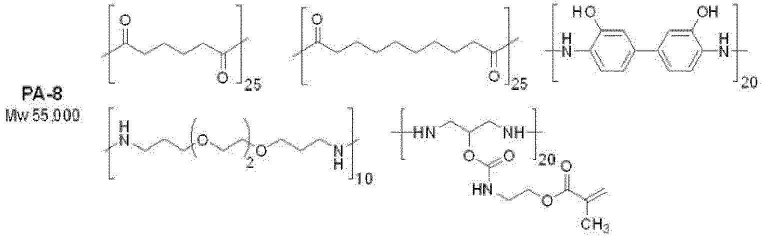

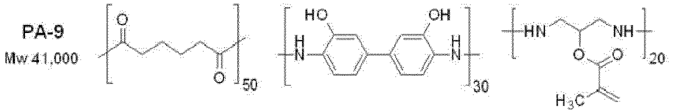

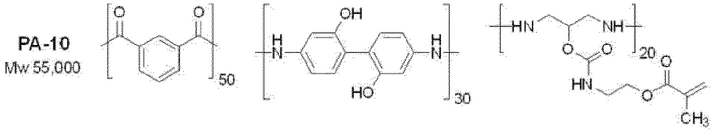

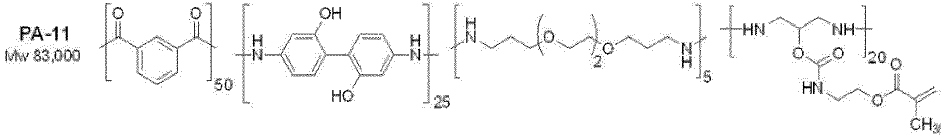

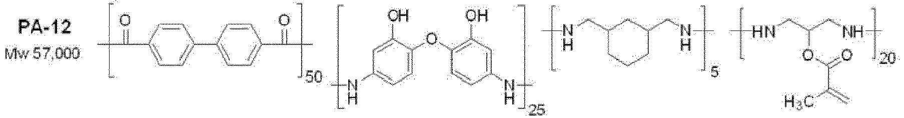

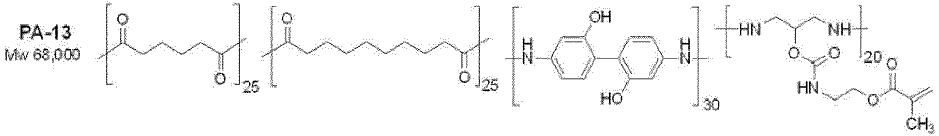

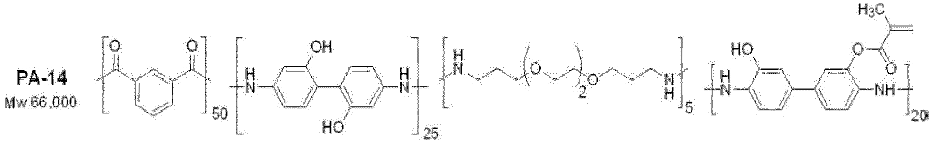

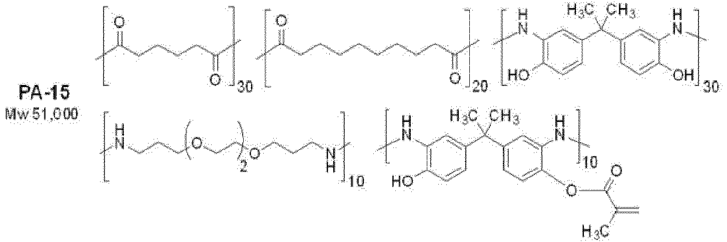

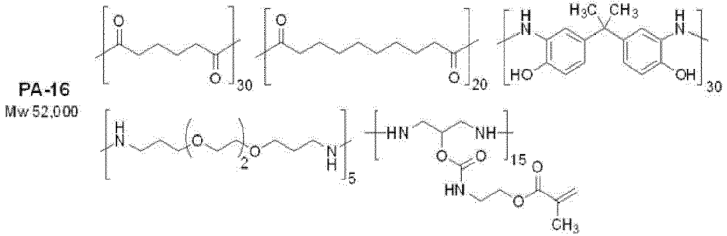

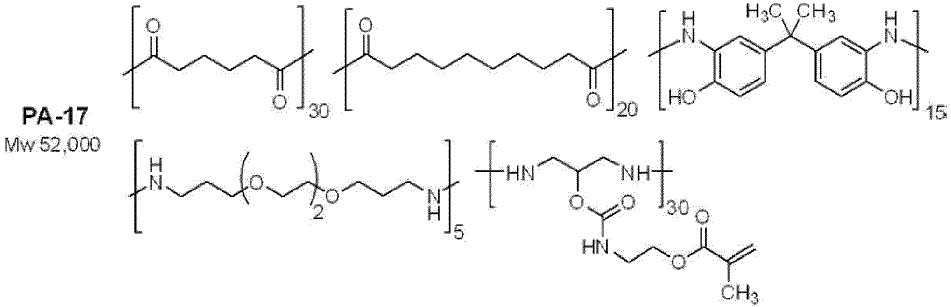

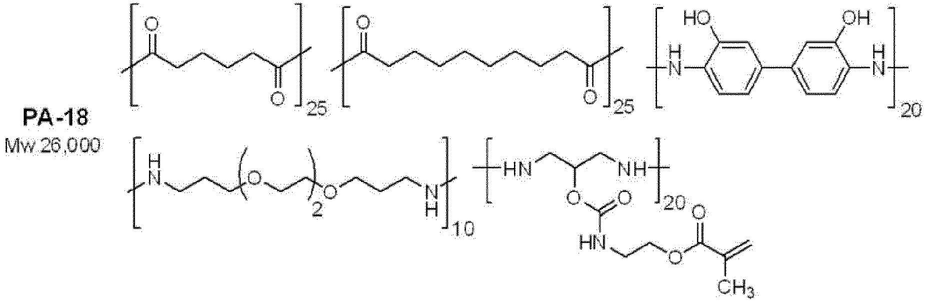

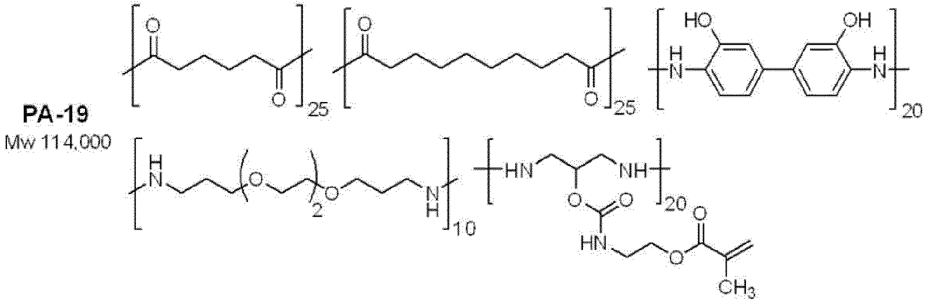

Further, it is needless to say that the exemplary compounds can be rewritten as described below using PA-1 as an example.

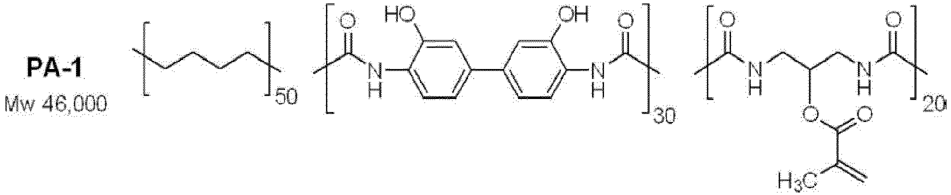

The weight-average molecular weight of the specific polymer compound in the photosensitive resin composition of the present disclosure is preferably in a range of 5000 to 300000, more preferably in a range of 10000 to 200000, and still more preferably in a range of 30000 to 100000.

Further, it is preferable that the weight-average molecular weight or the number average molecular weight in the present disclosure is measured according to a standard polystyrene conversion method using a gel permeation chromatography (GPC) method. It is preferable that the measurement according to the gel permeation chromatography method in the present disclosure is performed using a column filled with a polystyrene cross-linked gel (TSKgel SuperAWM-H; manufactured by Tosoh Corporation) as a GPC column and N-methylpyrrolidone (0.01 mol/L of each of phosphoric acid and lithium bromide) as a GPC solvent.

The specific polymer compound may be used alone or in combination of two or more kinds thereof.

The content of the specific polymer compound in the image recording layer is preferably in a range of 10% to 90% by mass, more preferably in a range of 20% to 80% by mass, and still more preferably in a range of 30% to 70% by mass with respect to the total mass of the image recording layer. In a case where the content is in the above-described range, the pattern formability at the time of development becomes excellent. Further, the total solid content of the photosensitive resin composition indicates an amount obtained by excluding volatile components such as a solvent.

### <Polymerization initiator>

The image recording layer contains a polymerization initiator.

As the polymerization initiator used in the present disclosure, a compound that generates a radical using light or heat or the energy of both light and heat, and starts and promotes polymerization of a polymerizable compound can be used. Specific examples thereof include known thermal polymerization initiators, compounds having bonds with small bond dissociation energy, and photopolymerization initiators.

In the present disclosure, it is preferable that the polymerization initiator is a photopolymerization initiator and more preferable that the polymerization initiator is a photo-radical polymerization initiator.

The polymerization initiator can be used alone or in combination of two or more kinds thereof.

Examples of the radical polymerization initiator include (a) an organic halogenated compound, (b) a carbonyl compound, (c) an organic peroxide compound, (d) an azo type polymerization initiator, (e) an azide compound, (f) a metallocene compound, (g) a hexaarylbiimidazole compound, (h) an organic boric acid compound, (i) a disulfonic acid compound, (j) an oxime ester compound, and (k) an onium salt compound.

Particularly from the viewpoints of reactivity and stability, a diazonium salt, an iodonium salt, and a sulfonium salt included in the (g) hexaarylbiimidazole compound, the (j) oxime ester compound, and the (k) onium salt compound from among the above-described compounds are suitably exemplified as the polymerization initiator in the present disclosure. In the present disclosure, the onium salt does not function as an acid generator but as an ionic radical polymerization initiator.

As the polymerization initiator, it is preferable to contain at least an onium salt compound, more preferable to contain at least an iodonium salt compound or a sulfonium salt compound, and still more preferable to contain at least a diaryliodonium salt compound or a triaryl sulfonium salt compound.

As the diaryliodonium salt compound or the triaryl sulfonium salt compound, from the viewpoint of the balance between reactivity and stability, a diaryliodonium salt compound having an electron-donating group on an aromatic ring or a triaryl sulfonium salt compound having an electron-withdrawing group on an aromatic ring is preferable; a diaryliodonium salt compound having two or more alkoxy groups on an aromatic ring is more preferable; and a diaryliodonium salt compound having three or more alkoxy groups on an aromatic ring is particularly preferable.

Further, as the polymerization initiator, it is particularly preferable to contain an iodonium salt compound and a sulfonium salt compound.

The polymerization initiator may be used alone or in combination of two or more kinds thereof.

The content of the polymerization initiator in the image recording layer is preferably in a range of 0.1% to 50% by mass, more preferably in a range of 0.5% to 30% by mass, and particularly preferably in a range of 1% to 20% by mass with respect to the total mass of the image recording layer. In a case where the content thereof is in the above-described range, curability with high sensitivity is obtained and excellent sensitivity and excellent stain resistance of a non-image area during printing are obtained.

### <Polymerizable compound>

It is preferable that the image recording layer contains a polymerizable compound.

The polymerizable compound used in the present disclosure is a polymerizable compound containing at least one ethylenically unsaturated group and is selected from compounds containing at least one and preferably two or more terminal ethylenically unsaturated groups. Such a compound group has been widely known in the industrial field and these can be used without particular limitation in the present disclosure. The polymerizable compounds have chemical forms such as a monomer, a pre-polymer, that is, a dimer, a trimer, an oligomer, or a mixture of these, and a copolymer of these.

As the examples of the monomer and the copolymer thereof, compounds having an ethylenically unsaturated double bond described in paragraphs 0105 to 0119 of JP2008-107758A are suitably used.

It is preferable that the polymerizable compound in the present disclosure is a compound that does not have a structure represented by Formula 1.

Further, as the polymerizable compound in the present disclosure, a compound having a molecular weight of less than 5000 is preferable, a compound having a molecular weight of less than 2000 is more preferable, and a compound having a molecular weight of less than 1000 is still more preferable.

The details of the structures of the polymerizable compounds, whether to be used alone or in combination, and the usage method such as the addition amount can be optionally set according to the performance design of the lithographic printing plate precursor. For example, from the viewpoint of the photosensitive speed, a structure having a large amount of unsaturated groups per molecule is preferable. In many cases, bi- or higher functional groups are preferable. Further, in order to increase the strength of an image area, that is, a cured film, tri- or higher functional groups are more preferable, and a method of adjusting both of photosensitivity and strength by combining polymerizable compounds having different functional numbers and/or different polymerizable groups (for example, an acrylic acid ester compound, a methacrylic acid ester compound, a styrene compound, and a vinyl ether compound) is useful. Compounds having a high molecular weight or compounds having excellent hydrophobicity are excellent in photosensitive speed or film hardness. However, the development speed or deposition in a developer is not preferable in some cases. In terms of compatibility with other components (for example, a binder polymer, a polymerization initiator, and a colorant) in an image recording layer and dispersibility, a method of selecting or using a polymerizable compound is an important factor. For example, the compatibility can be improved by using compounds with low purity or combining two or more compounds.

The polymerizable compound may be used alone or in combination of two or more kinds thereof.

The content of the polymerizable compound in the image recording layer is preferably in a range of 5% to 80% by mass and more preferably in a range of 25% to 75% by mass with respect to the total mass of the image recording layer.

### <Sensitizing dye>

It is preferable that the image recording layer contains a sensitizing dye.

The sensitizing dye used in the present disclosure can be used without particular limitation as long as the sensitizing dye absorbs light at the time of image exposure to enter an excited state, donates energy to the polymerization initiator through electron transfer, energy transfer, or heat generation, and improves the function of initiating polymerization. Particularly, a sensitizing dye having a maximum absorption wavelength at 300 to 600 nm or 700 to 1300 nm is preferably used.

Preferred examples of the sensitizing dye having a maximum absorption wavelength at 300 to 600 nm include dyes such as merocyanines, benzopyrans, coumarins, aromatic ketones, anthracenes, styryls, and oxazoles.

Specific preferred examples of such sensitizing dyes include compounds described in paragraphs 0047 to 0053 of JP2007-58170A, paragraphs 0036 and 0037 of JP2007-93866A, and paragraphs 0042 to 0047 of JP2007-72816A.

Further, sensitizing dyes described in JP2006-189604A, JP2007-171406A, JP2007-206216A, JP2007-206217A, JP2007-225701A, JP2007-225702A, JP2007-316582A, and JP2007-328243A can be also preferably used.

It is preferable that the photosensitive resin composition of the present disclosure contains a sensitizing dye (hereinafter, also referred to as an "infrared absorbent") having a maximum absorption wavelength of 700 to 1300 nm.

In the present disclosure, in a case where exposure is performed using laser emitting infrared rays having a wavelength of 700 to 1300 nm as a light source, an infrared absorbent having a maximum absorption wavelength in this wavelength range is preferably used as a sensitizing dye.

The infrared absorbent has a function of converting absorbed infrared rays into heat. Due to the heat generated at this time, the radical generator (polymerization initiator) is thermally decomposed to generate a radical.

As the infrared absorbent used in the present disclosure, a dye or a pigment having a maximum absorption wavelength of 700 to 1300 nm is preferable. Infrared absorbents described in paragraphs 0123 to 0139 of JP2008-107758A are suitably used as the infrared absorbent.

Specifically, commercially available dyes or known dyes described in documents (for example, "Dye Handbook", compiled by The Society of Synthetic Organic Chemistry, Japan, published in 1970) can be used as the dye. Specific examples thereof include dyes such as an azo dye, a metal complex azo dye, a pyrazolone azo dye, a naphthoquinone dye, an anthraquinone dye, a phthalocyanine dye, a carbonium dye, a quinone imine dye, a methine dye, a cyanine dye, a squarylium coloring agent, a pyrylium salt, and a metal thiolate complex. Preferred examples of such dyes include cyanine dyes described in JP1983-125246A (JP-S58-125246A), JP1984-84356A (JP-S59-84356A), JP1984-202829A (JP-S59-202829A), or JP1985-78787A (JP-S60-78787A), methine dyes described in JP1983-173696A (JP-S58-173696A), JP1983-181690A (JP-S58-181690A), or JP1983-194595A (JP-S58-194595A), naphthoquinone dyes described in JP1983-112793A (JP-S58-112793A), JP1983-224793A (JP-S58-224793A), JP1984-48187A (JP-S59-48187A), JP1984-73996A (JP-S59-73996A), JP1985-52940A (JP-S60-52940A), or JP1985-63744A (JP-S60-63744A), squarylium coloring agents described in JP1983-112792A (JP-S58-112792A), and cyanine dyes described in GB434875B. In addition, as the dye, the near infrared absorbing sensitizers described in US5156938A are also suitably used, also, substituted aryl benzo(thio)pyrylium salts described in US3881924A, trimethine thiapyrylium salts described in JP1982-142645A (JP-S57-142645A) (US4327169A), pyrylium-based compounds described in JP1983-181051A (JP-S58-181051A), JP1983-220143A (JP-S58-220143A), JP1984-41363A (JP-S59-41363A), JP1984-84248A (JP-S59-84248A), JP1984-84249A (JP-S59-84249A), JP1984-146063A (JP-S59-146063A), or JP1984-146061A (JP-S59-146061A), cyanine coloring agents described in JP1984-216146A (JP-S59-216146A), pentamethinethiopyrylium salts described in US4283475A, or pyrylium compounds described in JP1993-13514B (JP-H05-13514B) or JP1993-19702B (JP-H05-19702B) are preferably used. Further, preferred other examples of the dye include near infrared absorbing dyes represented by Formulae (I) and (II) which are described in US4756993A.

In addition, other preferred examples of the infrared absorbing coloring agent used in the present disclosure include specific indolenine cyanine coloring agents described in JP2002-278057A shown below.

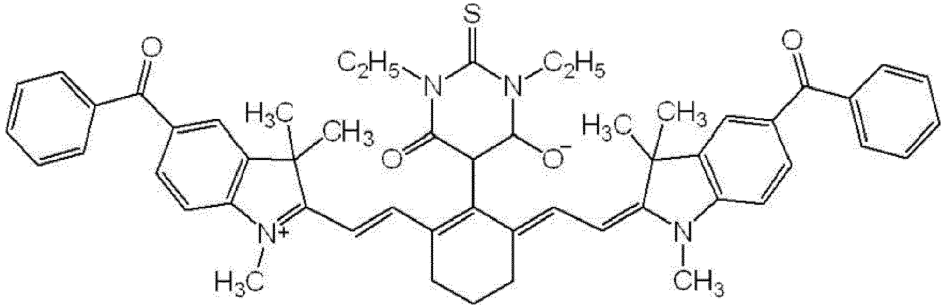

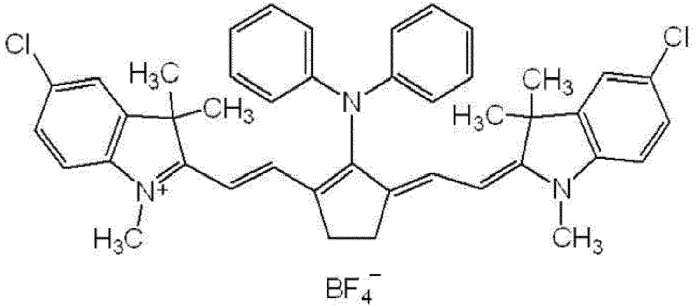

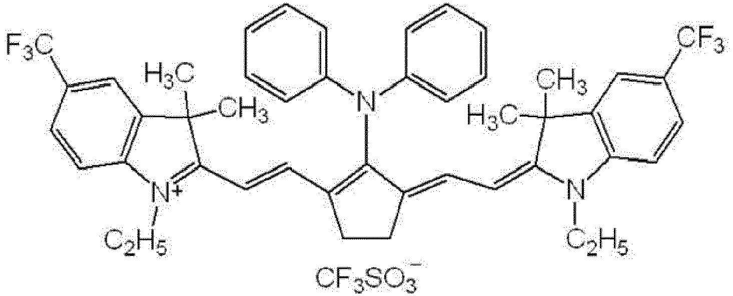

Among these dyes, a cyanine coloring agent, a squarylium coloring agent, a pyrylium salt, a nickel thiolate complex, and an indolenine cyanine coloring agent are more preferable. Furthermore, a cyanine coloring agent or an indolenine cyanine coloring agent is preferable and a cyanine coloring agent represented by Formula a is particularly preferable. The cyanine coloring agent represented by Formula a imparts high polymerization activity in an image recording layer and has excellent stability and economic efficiency.

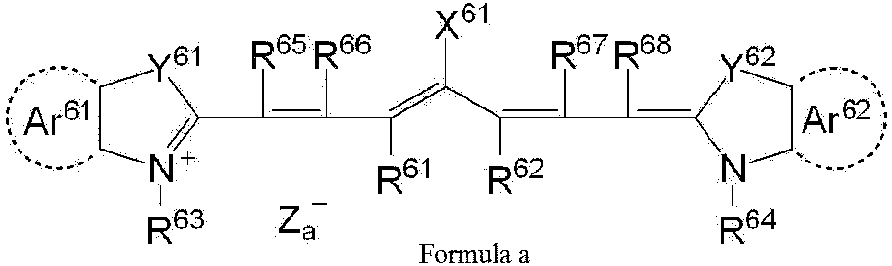

In Formula a, X⁶¹ represents a hydrogen atom, a halogen atom, -N(Ar⁶³)₂, -X⁶²-L⁶¹, or a group represented by Formula a. Here, Ar⁶³ represents an aromatic hydrocarbon group having 6 to 14 carbon atoms, and the aromatic hydrocarbon group may have one or more substituents selected from the group consisting of a halogen atom, an alkyl group, an allyl group, an alkenyl group, an alkynyl group, a cyano group, a carboxy group, a nitro group, an amide group, an ester group, an alkoxy group, an amino group, and a hetero ring group. In addition, these substituents may be substituted with the above-described substituents. Further, X⁶² represents an oxygen atom, a sulfur atom, or -N(Rₓ)-, and Rₓ represents a hydrogen atom or a hydrocarbon group having 1 to 10 carbon atoms. L⁶¹ represents a hydrocarbon group having 1 to 12 carbon atoms, an aromatic ring group having heteroatoms, or a hydrocarbon group having heteroatoms and 1 to 12 carbon atoms. Further, the heteroatom here indicates N, S, O, a halogen atom, or Se.

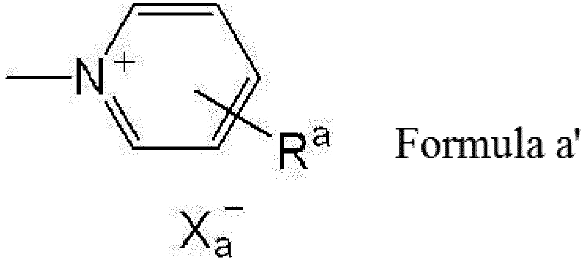

In Formula a', Xₐ⁻ has the same definition as that for Zₐ⁻ described below, and R^{a} represents a substituent selected from the group consisting of a hydrogen atom, an alkyl group, an aryl group, a substituted or unsubstituted amino group, and a halogen atom.

R⁶¹ and R⁶² each independently represent a hydrocarbon group having 1 to 12 carbon atoms. From the viewpoint of storage stability of the photosensitive resin composition, it is preferable that R⁶¹ and R⁶² represent a hydrocarbon group having 2 to 12 carbon atoms and also preferable that both of R⁶¹ and R⁶² are bonded to each other to form a 5- or 6-membered ring.

Ar⁶¹ and Ar⁶² may be the same as or different from each other and represent an aromatic hydrocarbon group which may have a substituent. Preferred examples of the aromatic hydrocarbon group include a benzene ring and a naphthalene ring. Further, preferred examples of the substituent include a hydrocarbon group having 1 to 12 carbon atoms, a halogen atom, and an alkoxy group having 1 to 12 carbon atoms.

Y⁶¹ and Y⁶² may be the same as or different from each other and represent a sulfur atom or a dialkylmethylene group having 3 to 12 carbon atoms.

R⁶³ and R⁶⁴ may be the same as or different from each other and represent a hydrocarbon group having 1 to 20 carbon atoms which may have a substituent. Preferred examples of the substituent include an alkoxy group having 1 to 12 carbon atoms, a carboxyl group, and a sulfo group.

R⁶⁵ to R⁶⁸ may be the same as or different from one another and each represent a hydrogen atom or a hydrocarbon group having 1 to 12 carbon atoms. From the viewpoint of availability of a raw material, it is preferable that R⁶⁵ to R⁶⁸ each represent a hydrogen atom. In addition, Zₐ⁻ represents a counter anion. Here, in a case where the cyanine coloring agent represented by Formula a has an anionic substituent in the structure thereof so that neutralization of the charge is not necessary, Zₐ⁻ is not necessary. From the viewpoint of the storage stability of the photosensitive resin composition, as Zₐ⁻, a halide ion, a perchlorate ion, a tetrafluoroborate ion, a hexafluorophosphate ion, or a sulfonate ion is preferable; and a perchlorate ion, a hexafluorophosphate ion, or an arene sulfonate ion is more preferable.

The sensitizing dye may be used alone or in combination of two or more kinds thereof.

Further, a cyanine coloring agent containing an electron-withdrawing group or a heavy atom-containing substituent at an indolenine site of both terminals is preferable, and the coloring agents described in JP2002-278057A are suitably used as the cyanine coloring agent. It is most preferable that X⁶¹ represents a diarylamino group, and a cyanine coloring agent containing an electron-withdrawing group at an indolenine site of both terminals.

The amount of the sensitizing dye to be added in the image recording layer is preferably in a range of 0.5% to 20% by mass and more preferably in a range of 1.0% to 10% by mass with respect to the total mass of the image recording layer. In a case where the amount thereof is in the above-described range, the absorption of actinic rays through exposure is efficiently performed so that high sensitivity is also achieved, and there is no concern that the uniformity or strength of a film is adversely affected.

### <Other components>

Other components can be appropriately added to the image recording layer according to the use thereof, the production method, and the like.

As other components, known additives can be used, and examples thereof include a chain transfer agent, a solvent, a development accelerator, a hydrophilic polymer, a surfactant, a print-out agent or a colorant, a polymerization inhibitor, a hydrophobic low-molecular-weight compound, inorganic particles, organic particles, a co-sensitizer, a plasticizer, a basic compound, and a wax agent.

Hereinafter, preferred additives will be described.

It is preferable that the image recording layer contains a chain transfer agent.

The chain transfer agent is defined, for example, in Polymer Dictionary Third Edition (edited by The Society of Polymer Science, Japan, 2005), pp. 683 to 684. For example, a compound group having SH, PH, SiH, and GeH in a molecule is used as the chain transfer agent. With these, radicals are generated by donating hydrogen to low active radical species or radicals can be generated by deprotonation after oxidation.

Further, particularly, thiol compounds (such as 2-mercaptobenzimidazoles, 2-mercaptobenzthiazoles, 2-mercaptobenzoxazoles, 3-mercaptotriazoles, and 5-mercaptotetrazoles) can be preferably used as the chain transfer agent.

The content of the chain transfer agent in the image recording layer is preferably in a range of 0.01 to 20% by mass, more preferably in a range of 1 to 10% by mass, and particularly preferably in a range of 1 to 5% by mass with respect to the total mass of the image recording layer.

The image recording layer may further contain various additives as necessary.

Examples of the additives include a surfactant for promoting developability and improving the coated surface state; a hydrophilic polymer for improving developability and improving dispersion stability of microcapsules; a colorant or a print-out agent for visually recognizing an image area and a non-image area; a polymerization inhibitor for preventing unnecessary thermal polymerization of a polymerizable compound during production or storage of the image recording layer; a hydrophobic low-molecular-weight compound such as a higher fatty derivative for preventing polymerization inhibition due to oxygen; inorganic particles and organic particles for improving cured film hardness of an image area; a co-sensitizer for improving sensitivity; and a plasticizer for improving plasticity. As these compounds, known compounds described in paragraphs 0161 to 0215 of JP2007-206217A, paragraph 0067 of JP2005-509192A, and paragraphs 0023 to 0026 and 0059 to 0066 of JP2004-310000A can be used. As the surfactant, the following surfactants which may be added to a developer can also be used.

The hydrophilic polymer is a polymer other than the specific polymer compound. In a case where the image recording layer contains the hydrophilic polymer, the content thereof is preferably less than the content of the specific polymer compound and more preferably less than a half the content of the specific polymer compound.

### - Formation of image recording layer -

The image recording layer can be formed by dissolving and/or dispersing respective components described above in a solvent and coating a suitable support with the solution.

Examples of the solvent used here include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl urea, N-methylpyrrolidone, dimethyl sulfoxide, sulfolane, γ-butyrolactone, and toluene, and the present disclosure is not limited to these. These solvents are used alone or in mixture.

The image recording layer is suitably formed by coating the support with the composition obtained by dissolving and/or dispersing the respective components described above in a solvent according to a known method such as a bar coater coating method and drying the support.

The coating amount (solid content) of the image recording layer on the support to be obtained after being applied and dried varies depending on the use thereof, but is preferably in a range of 0.3 to 3.0 g/m². In a case where the amount thereof is in the above-described range, excellent sensitivity and excellent film properties of the image recording layer are obtained.

### <Support having hydrophilic surface>

It is preferable that the negative type lithographic printing plate precursor of the present disclosure includes the image recording layer on a support having a hydrophilic surface.

Examples of the support having a hydrophilic surface in the negative type lithographic printing plate precursor of the present disclosure include a polyester film and an aluminum plate. Among these, an aluminum plate which has excellent dimensional stability, is relatively inexpensive, and can be provided with a surface that is excellent in hydrophilicity or strength by performing a surface treatment as necessary is preferable. Further, a composite sheet formed by bonding an aluminum sheet onto a polyethylene terephthalate film described in JP1973-18327B (JP-S48-18327B) is also preferable.

An aluminum plate as a suitable support in the present disclosure is a metal plate containing dimensionally stable aluminum as a main component and is selected from an alloy plate which contains aluminum as a main component and a trace amount of heteroelements; a plastic film on which aluminum (alloy) is laminated or vapor-deposited; and paper, in addition to a pure aluminum plate. In the description below, a support formed of aluminum or an aluminum alloy exemplified above is collectively referred to as an aluminum support.

Examples of the heteroelements contained in the aluminum alloy include silicon, iron, manganese, copper, magnesium, chromium, zinc, bismuth, nickel, and/or titanium, and the content of the heteroelements in the alloy is 10% by mass or less. In the present disclosure, a pure aluminum plate is suitable. However, since completely pure aluminum is difficult to produce due to the refining technology, the plate may contain a small amount of heteroelements. The composition of the aluminum plate applied in the present disclosure as described above is not specified, and known materials which have been used in the related art, such as JIS A 1050, JIS A 1100, JIS A 3103, and JIS A 3005, can be used as appropriate.

In addition, the thickness of the aluminum plate used in the present disclosure is approximately in a range of 0.1 mm to 0.6 mm. The thickness can be appropriately changed according to the size of a printing press, the size of a printing plate, and the user's request.

It is preferable that the aluminum support is subjected to a hydrophilic treatment. Preferred examples of the hydrophilic treatment include surface treatments described in paragraphs 0252 to 0258 of JP2008-107758A.

In the negative type lithographic printing plate precursor of the present disclosure, it is not necessary for the support and the image recording layer to be brought into direct contact with each other. For example, an undercoat layer can be suitably provided between the support and the image recording layer as necessary.

Further, in the negative type lithographic printing plate precursor of the present disclosure, a protective layer can be suitably provided on the image recording layer.

### <Undercoat layer>

It is preferable that the negative type lithographic printing plate precursor of the present disclosure includes an undercoat layer between the support and the image recording layer.

Since the undercoat layer functions as a heat insulating layer at the time of image exposure, heat generated by exposure using an infrared laser or the like does not diffuse to the support and is efficiently used. Therefore, the undercoat layer contributes to improvement of the sensitivity.

It is preferable that the undercoat layer is formed of an alkali-soluble polymer. An alkali-soluble polymer in a non-image area is rapidly dissolved in a developer and removed by using an alkali-soluble polymer, and thus contributes to improvement of developability.

Hereinafter, specific examples of the alkali-soluble polymer preferably used for the undercoat layer will be described, but the present disclosure is not limited thereto. In the specific examples below, Mw represents the weight-average molecular weight, and each numerical value accompanying a repeating unit represents the content (% by mole) of the repeating unit.

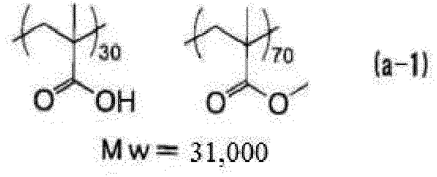

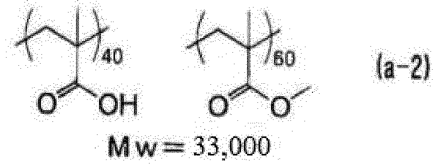

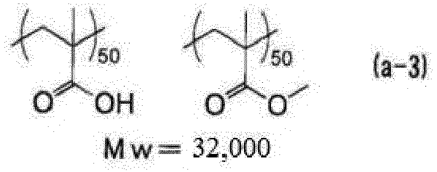

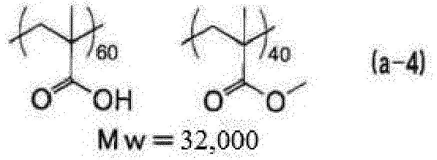

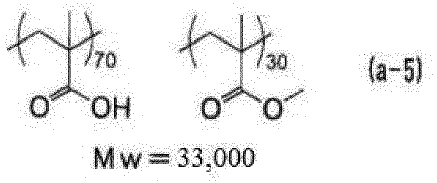

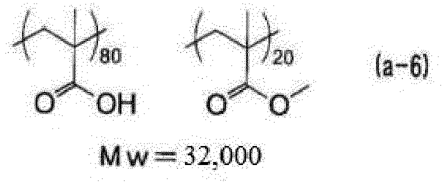

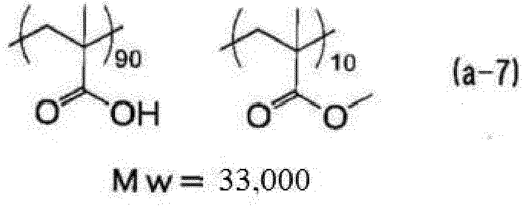

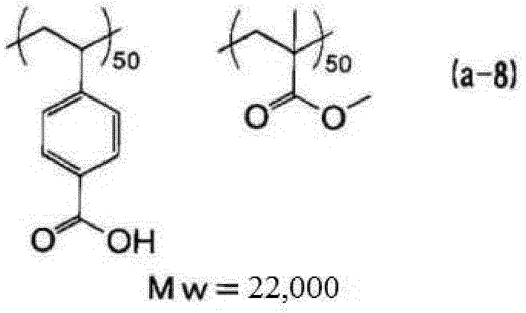

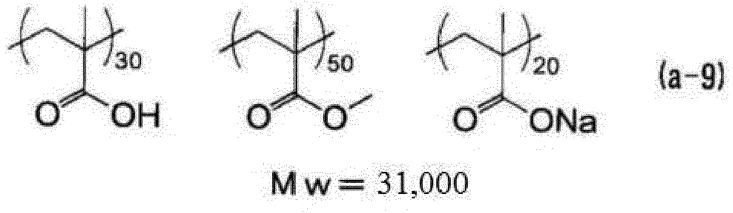

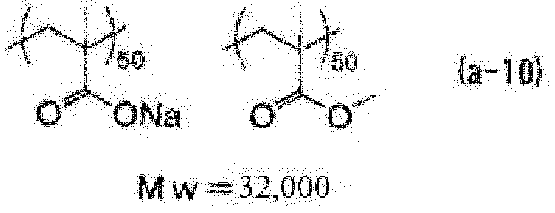

The undercoat layer can be formed by coating the support with an undercoat layer coating solution that contains an alkali-soluble polymer. The coating amount of the undercoat layer coating solution is preferably in a range of 1 to 1000 mg/m², more preferably in a range of 1 to 50 mg/m², and still more preferably in a range of 5 to 20 mg/m².

A pH adjusting agent such as phosphoric acid, phosphorus acid, hydrochloric acid, or low-molecular organic sulfonic acid or a wetting agent such as saponin can be added, as an optional component, to the undercoat layer coating solution within a range not impairing the effects of the present disclosure.

The coating amount (solid content) of the undercoat layer in the negative type lithographic printing plate precursor of the present disclosure is preferably in a range of 1 to 200 mg/m², more preferably in a range of 1 to 50 mg/m², and still more preferably in a range of 5 to 20 mg/m². In a case where the coating amount thereof is in the above-described range, printing durability can be sufficiently obtained.

### <Protective layer>

In the negative type lithographic printing plate precursor of the present disclosure, it is preferable that a protective layer (oxygen blocking layer) is provided on the image recording layer in order to block diffusion penetration of oxygen that disturbs a polymerization reaction during exposure.

As the material of the protective layer, any of a water-soluble polymer and a water-insoluble polymer can be appropriately selected and used, and two or more kinds thereof can be mixed and used in combination as necessary. Specific examples thereof include polyvinyl alcohol, modified polyvinyl alcohol, polyvinylpyrrolidone, a water-soluble cellulose derivative, and poly(meth)acrylonitrile. Among these, a water-soluble polymer compound having relatively excellent crystallinity is preferably used. Specifically, in a case where polyvinyl alcohol is used as a main component, this leads to excellent results particularly for basic characteristics such as oxygen blocking properties and development removability.

Since polyvinyl alcohol used for the protective layer has necessary oxygen blocking properties and water solubility, a part of the polyvinyl alcohol may be substituted with an ester, an ether, or an acetal as long as the polyvinyl alcohol contains a necessary unsubstituted vinyl alcohol unit. Further, similarly, a part thereof may contain other copolymerization components. The polyvinyl alcohol can be obtained by hydrolyzing polyvinyl acetate. Specific examples of the polyvinyl alcohol include those in which the degree of hydrolysis is in a range of 69.0% to 100% by mole and the number of polymerization repeating units is in a range of 300 to 2400.

Specific examples thereof include PVA-102 PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706, and L-8 (all manufactured by KURARAY CO., LTD.). The polyvinyl alcohol can be mixed and used alone or in combination of two or more kinds thereof. The content of the polyvinyl alcohol in the protective layer is preferably in a range of 20% to 95% by mass and more preferably in a range of 30% to 90% by mass.

Further, the modified polyvinyl alcohol can also be preferably used. Particularly, acid-modified polyvinyl alcohol containing a carboxylic acid group or a sulfonic acid group is preferably used. Specifically, polyvinyl alcohol described in JP2005-250216A and JP2006-259137A is suitably exemplified.

In a case where polyvinyl alcohol is mixed with other materials and used, from the viewpoints of oxygen blocking properties and development removability, modified polyvinyl alcohol, polyvinylpyrrolidone, or a modified product thereof is preferable as the component to be mixed. The content thereof in the protective layer is preferably in a range of 3.5% to 80% by mass, more preferably in a range of 10% to 60% by mass, and still more preferably in a range of 15% to 30% by mass.

The flexibility can be imparted to the protective layer by adding several mass percent of glycerin, dipropylene glycol, or the like to the above-described polymer. Further, several mass percent of an anionic surfactant such as sodium alkyl sulfate or sodium alkyl sulfonate; an amphoteric surfactant such as alkylaminocarboxylate or alkylaminodicarboxylate; or a non-ionic surfactant such as polyoxyethylene alkyl phenyl ether can be added to the above-described polymer.

For the purpose of improving oxygen blocking properties or surface protection properties of the photosensitive layer, it is also preferable that the protective layer contains an inorganic layered compound. Among examples of the inorganic layered compound, a fluorine-based swellable synthetic mica which is a synthetic inorganic layered compound is particularly useful. Specifically, inorganic layered compounds described in JP2005-119273A are suitably exemplified.

It is preferable that the protective layer contains inorganic particles (inorganic filler) or organic resin particles (organic filler) and more preferable that the protective layer contains organic resin particles.

Further, the protective layer may contain additives such as a thickener or a polymer compound. Known additives can be used as the additives.

Only one or two or more protective layers may be formed, but it is preferable that one or two protective layers are formed and more preferable that two layers of protective layers are formed.

The coating amount of the protective layer is preferably in a range of 0.05 to 10 g/m², more preferably in a range of 0.1 to 5 g/m² in a case where the protective layer contains an inorganic layered compound, and still more preferably in a range of 0.5 to 5 g/m² in a case where the protective layer does not contain an inorganic layered compound.

The negative type lithographic printing plate precursor of the present disclosure may further include known layers other than those described above.

For example, the negative type lithographic printing plate precursor of the present disclosure may have a back coat layer on the rear surface of the support as necessary.

Known back coat layers can be used as the back coat layer.

### (Method of preparing lithographic printing plate)

A method of preparing a lithographic printing plate of the present disclosure is a preparation method using the negative type lithographic printing plate precursor of the present disclosure and it is preferable that the method includes, in order, an exposure step of image-exposing the negative type lithographic printing plate precursor of the present disclosure; and a development step of performing development by removing a non-exposed portion of the exposed negative type lithographic printing plate precursor using a developer.

Further, as the method of preparing a lithographic printing plate of the present disclosure, a method of setting the lithographic printing plate precursors of the present disclosure in a plate setter, automatically transporting the lithographic printing plate precursors one by one, image-exposing the lithographic printing plate precursors with light having a wavelength of 700 nm to 1300 nm, and performing a development treatment at a transport speed of 1.25 m/min or greater without substantially performing a heat treatment is exemplified.

Hereinafter, the image exposure and the development treatment will be described.

### <Exposure step>

It is preferable that the method of preparing a lithographic printing plate of the present disclosure includes an exposure step of image-exposing the negative type lithographic printing plate precursor of the present disclosure.

As a light source used for image exposure, a light source which can emit light having a wavelength of 300 nm to 1400 nm is preferable; and a light source which can emit light having a wavelength of 700 nm to 1300 nm is more preferable. Further, an infrared laser is also preferable. In the present disclosure, it is preferable that image exposure is performed using a solid-state laser or a semiconductor laser emitting infrared rays having a wavelength of 700 nm to 1300 nm. The output of the laser is preferably 100 mW or greater. In order to shorten the exposure time, it is preferable to use a multibeam laser device. In addition, the exposure time per pixel is preferably within 20 µ seconds. The energy to be applied to the lithographic printing plate precursor is preferably in a range of 10 to 300 mJ/cm². In a case where the energy is in the above-described range, the curing of the image recording layer is sufficiently promoted, and damage to an image recording layer caused by laser ablation can be prevented.

The image exposure can be carried out by overlapping a light beam of the light source. The overlapping means that the sub-scanning pitch width is smaller than the beam diameter. For example, in a case where the beam diameter is expressed by the half-width (FWHM) of the beam intensity, the overlapping can be quantitatively expressed by FWHM/sub-scanning pitch width (overlap coefficient). In the present disclosure, this overlap coefficient is preferably 0.1 or greater.

A scanning method of the light source of an exposure device which can be used in the present disclosure is not particularly limited, and examples thereof include a drum outer surface scanning method, a drum inner surface scanning method, and a planar scanning method. In addition, the channel of the light source may be a single channel or a multichannel, and the multichannel is preferably used in a case of drum outer surface scanning method.

In the present disclosure, as described above, it is preferable that the image-exposed lithographic printing plate precursor is subjected to a development treatment without performing a special heat treatment or a water-washing treatment. In a case where the heat treatment is not performed, the non-uniformity of an image caused by the heat treatment can be prevented. Further, in a case where the heat treatment and the water-washing treatment are not performed, a stable treatment with a high speed can be carried out during the development treatment.

### <Development step>

It is preferable that the method of preparing a lithographic printing plate of the present disclosure includes a development step of performing development by removing a non-exposed portion of the exposed negative type lithographic printing plate precursor using a developer.

During the development treatment applied in the present disclosure, it is preferable that the non-image area (non-exposed portion) of the image recording layer is removed using a developer.

In the present disclosure, as described above, the treatment speed during the development treatment, that is, the transport speed (line speed) of the lithographic printing plate precursor during the development treatment is preferably 1.25 m/min or greater and more preferably 1.35 m/min or greater. The upper limit of the transport speed is not particularly limited, but is preferably 3 m/min or less from the viewpoint of stability of transport.

The developer used in the development step is preferably an aqueous solution having a pH of 6.0 to 13.5 and more preferably an alkali aqueous solution having a pH of 8.5 to 13.5.

Further, it is preferable that the developer contains a surfactant. A surfactant contributes to improvement of processability.

As the surfactant used for the developer, any of an anionic surfactant, a nonionic surfactant, a cationic surfactant, and an amphoteric surfactant can be used, but an anionic surfactant or a nonionic surfactant is preferable as described above.

As the surfactant used for the developer of the present disclosure, the surfactants described in paragraphs 0128 to 0131 of JP2013-134341A can be used.

Examples of the developer suitably used during the development treatment include developers described in paragraphs 0288 to 0309 of JP2008-107758A.

The temperature of development is not particularly limited as long as the development can be carried out, but the temperature is preferably 60°C or lower and more preferably in a range of 15°C to 40°C. In the development treatment using an automatic developing machine, since the developer becomes fatigued according to the treatment amount, the processing capability may be restored using a replenisher or a fresh developer. As one example of the development or a treatment after the development, a method of performing alkali development, removing the alkali in a post-water washing step, performing a gum treatment in a gumming step, and performing drying in a drying step can be exemplified.

The lithographic printing plate precursor to which the development treatment has been applied is subjected to a post treatment using wash water, a rinse liquid containing a surfactant or the like, and a desensitizing liquid containing Arabic gum or a starch derivative, as described in JP1979-8002A (JP-S54-8002A), JP1980-115045A (JP-S55-115045A), and JP1984-58431A (JP-S59-58431A). The post treatment can be performed on the lithographic printing plate precursor of the present disclosure by combining these treatments.

According to the method of preparing a lithographic printing plate of the present disclosure, it is possible to perform post-heating or exposure of the entire surface with respect to the image which has been subjected to the development treatment for the purpose of improving the image strength or the printing durability.

Extremely strong conditions can be used for the heating after development. It is preferable that the heating after development is performed in a heating temperature range of 200°C to 500°C. In a case where the heating temperature is in the above-described range, an image-strengthening action is sufficiently obtained, and deterioration of the support and thermal decomposition or the like of the image area can be suppressed.

The lithographic printing plate obtained according to the method of preparing a lithographic printing plate of the present disclosure is mounted on an offset printing machine and suitably used for printing a large number of sheets.

Further, as a plate cleaner used for removing stain on a lithographic printing plate during printing, a plate cleaner for a PS plate which has been known in the related art is suitably used. Examples thereof include multi-cleaners CL-1, CL-2, CP, CN-4, CN, CG-1, PC-1, SR, and IC (manufactured by Fujifilm Corporation).

### Examples

Hereinafter, embodiments of the present invention will be described in detail with reference to examples, but the present disclosure is not limited to these. Moreover, "part" and "%" in the examples respectively indicate "part by mass" and "% by mass" unless otherwise specified.

Further, polymer compounds PA-1 to PA-19 used in examples are respectively the same as PA-1 to PA-19 described above.

### (Examples 1 to 25 and Comparative Examples 1 to 8)

### <Preparation of support>

A surface treatment described below was performed using an aluminum plate (JIS A 1050) having a thickness of 0.30 mm and a width of 1030 mm.

### - Surface treatment -

The surface treatment was carried out by continuously performing various treatments of (a) to (f) described below. Further, liquid cutting was performed using a nip roller after each treatment and the washing treatment with water.
(a) The aluminum plate was subjected to an etching treatment using an aqueous solution at a temperature of 70°C, in which the concentration of caustic soda was 26% by mass and the concentration of aluminum ions was 6.5% by mass. Next, 5 g/m² of the aluminum plate was dissolved therein, and then washed with water.
(b) A desmutting treatment was performed using an aqueous solution having a nitric acid concentration of 1% by mass (containing 0.5% by mass of aluminum ions) at a temperature of 30°C with a spray, and then washing with water was performed.
(c) An electrochemical surface roughening treatment was continuously performed using an AC voltage of 60 Hz. As the electrolyte at this time, a 1 mass% aqueous solution in nitric acid (containing 0.5% by mass of aluminum ions and 0.007% by mass of ammonium ions) was used and the temperature was 30°C. Using a trapezoidal rectangular waveform AC having a time TP, until the current value reached a peak from zero, of 2 msec and the duty ratio of 1:1 as the AC power supply, the electrochemical surface roughening treatment was performed using a carbon electrode as a counter electrode. As an auxiliary anode, ferrite was used. The current density was 25 A/dm² as the peak current value, and the electric quantity was 250 C/cm² as the sum total of electric quantity at the time of anodization of the aluminum plate. 5% of the current flowing from the power source was allowed to separately flow into the auxiliary anode. Thereafter, washing with water was performed.
(d) The aluminum plate was subjected to an etching treatment at 35°C using an aqueous solution, in which the concentration of caustic soda was 26% by mass and the concentration of aluminum ions was 6.5% by mass, with a spray. Next, 0.2 g/m² of the aluminum plate was dissolved therein, smut components containing aluminum hydroxide, as the main component, generated at the time of electrochemical surface roughening using the AC current in the former stage were removed, the edge portion of the generated pit was dissolved, and the edge portion was made smooth. Next, washing with water was performed.
(e) A desmutting treatment was performed using an aqueous solution having a nitric acid concentration of 25% by mass (containing 0.5% by mass of aluminum ions) at a temperature of 60°C with a spray, and then washing with water with a spray was performed.
(f) An anodization treatment was performed at a temperature of 33°C and a current density of 5 A/dm² for 50 seconds in an aqueous solution having a sulfuric acid concentration of 170 g/L (containing 0.5% by mass of aluminum ions). Next, washing with water was performed. The anodized film weight at this time was 2.7 g/m². The surface roughness Ra of the aluminum support obtained in the above-described manner was 0.27 µm (measuring device: manufactured by TOKYO SEIMITSU CO., LTD., diameter of eclipse needle: 2 µm).

### <Formation of back coat layer>

Next, the rear surface of the aluminum support was coated with the following coating solution for an undercoat layer using a wire bar and then dried at 100°C for 10 seconds. The coating amount thereof was 0.5 g/m².

### - Coating solution for back coat layer -

- PR55422 (manufactured by Sumitomo Bakelite Co., Ltd., phenol/m-cresol/p-cresol = 5/3/2 (molar ratio), weight-average molecular weight: 5300): 0.44 parts
- Fluorine-based surfactant (MEGAFAC F-780-F, manufactured by DIC Corporation, 30 mass% solution in methyl isobutyl ketone (MIBK)): 0.002 parts
- Methanol: 3.70 parts
- 1-Methoxy-2-propanol: 0.92 parts

### <Formation of undercoat layer>

Next, the surface of the aluminum support was coated with the following coating solution for an undercoat layer using a wire bar and then dried at 100°C for 10 seconds. The coating amount thereof was 10 mg/m².

### - Coating solution for undercoat layer -

- Polymer compound A with the following structure (weight-average molecular weight: 10000): 0.05 parts
- Methanol: 27 parts
- Ion exchange water: 3 parts

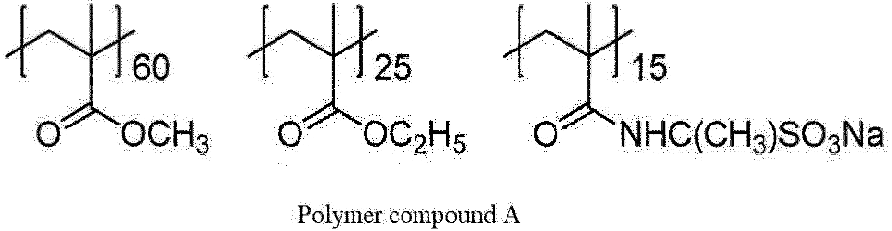

### <Formation of image recording layer>

The undercoat layer was coated with a photopolymerizable composition having the following composition such that the mass of the composition to be dried and applied was set to 1.4 g/m² and dried at 125°C for 34 seconds to obtain an image recording layer (photosensitive layer).

### - Photopolymerizable composition -

- Infrared absorbent (the following IR-1): 0.038 parts
- Polymerization initiator A (the following S-1): 0.061 parts
- Polymerization initiator B (polymerization initiator listed in Table 1): 0.094 parts
- Chain transfer agent (the following E-1): 0.015 parts
- Polymerizable compound (the following M-1, manufactured by Shin Nakamura Chemical Industry Co., Ltd., A-BPE-4): 0.425 parts
- Binder polymer A (polymer listed in Table 1): amount listed in Table 1
- Binder polymer B (the following B-1): amount listed in Table 1
- Binder polymer C (the following B-2): amount listed in Table 1
- Additive (the following A-1): 0.079 parts
- Polymerization inhibitor (the following Q-1); 0.0012 parts
- Ethyl violet (the following EV-1): 0.021 parts
- Fluorine-based surfactant (MEGAFAC F-780-F, manufactured by DIC Corporation, 30 mass% solution in methyl isobutyl ketone (MIBK)): 0.0081 parts
- Methyl ethyl ketone: 5.886 parts
- Methanol: 2.733 parts
- 1-Methoxy-2-propanol: 5.886 parts

The details of the infrared absorbent, the polymerization initiator, the chain transfer agent, the polymerizable compound, the binder polymer, the additive, the polymerization inhibitor, and the ethyl violet described above are as follows.

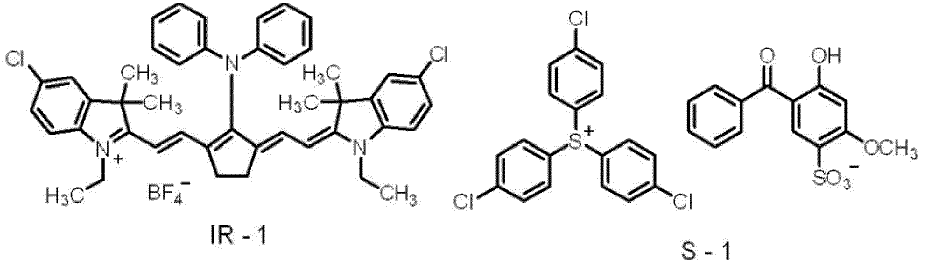

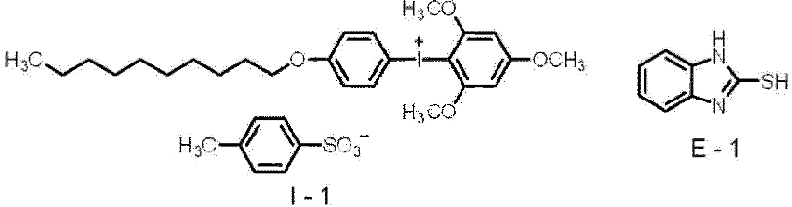

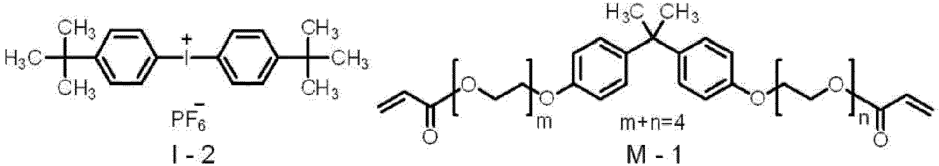

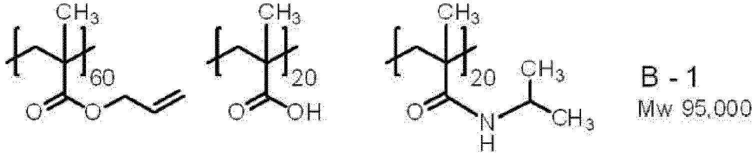

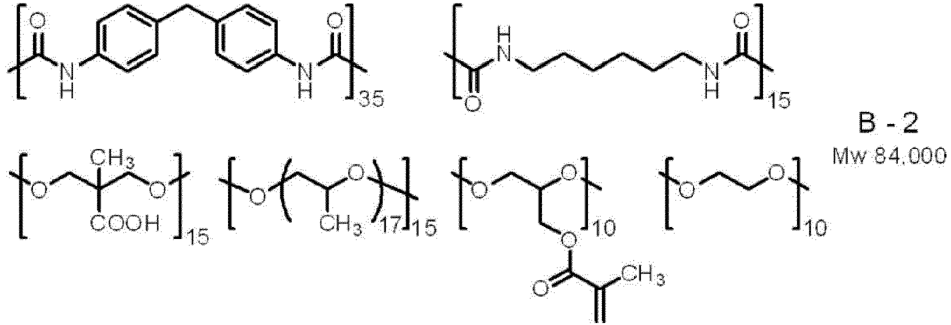

Further, the numerical values at the lower right of parentheses showing the constitutional units B-1 and B-2 indicate molar ratios, and the numerical values at the lower right of parentheses showing the propylene glycol units in B-2 indicate repetition numbers.

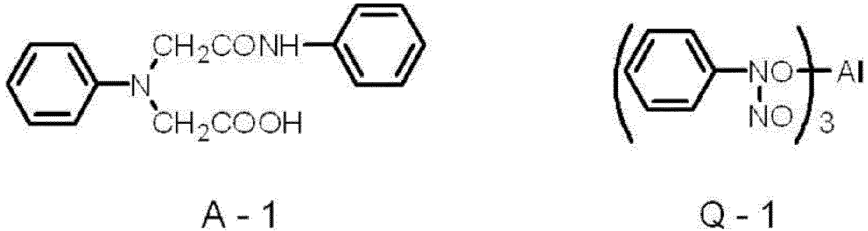

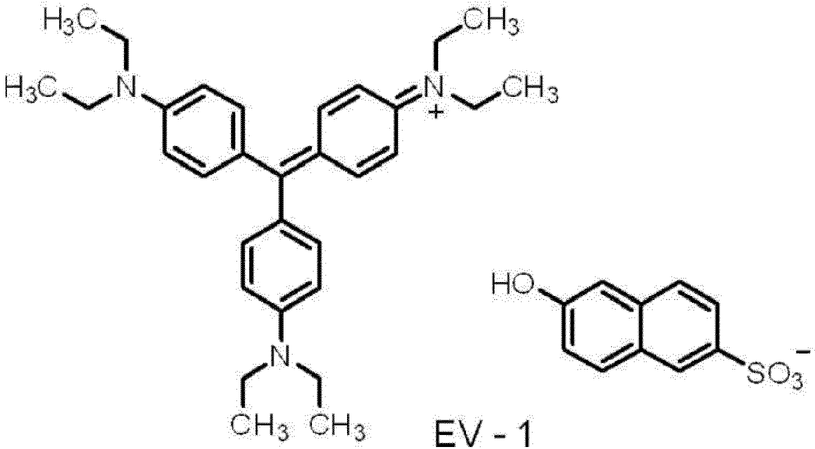

### <Formation of lower protective layer>

The surface of the image recording layer was coated with a mixed aqueous solution (coating solution for a protective layer) containing synthetic mica (SOMASIF MEB-3L, 3.2% aqueous dispersion liquid, manufactured by CO-OP CHEMICAL CO., LTD.), polyvinyl alcohol (GOHSERAN CKS-50, saponification degree of 99% by mole, polymerization degree of 300, sulfonic acid-modified polyvinyl alcohol, manufactured by Nippon Synthetic Chem Industry Co., Ltd.), a surfactant A (EMALEX 710, manufactured by Nihon Emulsion Co., Ltd.), and a surfactant B (ADEKA PLURONIC P-84, manufactured by ADEKA CORPORATION) using a wire bar and dried at 125°C for 30 seconds using a hot air dryer. The ratio of the content of synthetic mica (solid content)/polyvinyl alcohol/surfactant A/surfactant B in the mixed aqueous solution (coating solution for a protective layer) was 7.5/89/2/1.5 (% by mass). Further, the coating amount thereof (covering amount after the drying) was 0.5 g/m².

### <Formation of upper protective layer>

The surface of the lower protective layer was coated with a mixed aqueous solution (coating solution for a protective layer) containing an organic filler (ART PEARL J-7P, manufactured by Negami Chemical Industrial Co., Ltd.), synthetic mica (SOMASIF MEB-3L, 3.2% aqueous dispersion liquid, manufactured by CO-OP CHEMICAL CO., LTD.), polyvinyl alcohol (L-3266, saponification degree of 87% by mole, polymerization degree of 300, sulfonic acid-modified polyvinyl alcohol, manufactured by Nippon Synthetic Chem Industry Co., Ltd.), a thickener (CELLOGEN FS-B, manufactured by Dai-ichi Kogyo Seiyaku Co., Ltd.), a polymer compound A (the structure described above), and a surfactant (EMALEX 710, manufactured by Nihon Emulsion Co., Ltd.) using a wire bar and dried at 125°C for 30 seconds using a hot air dryer. The ratio of the content of organic filler/synthetic mica (solid content)/polyvinyl alcohol/thickener/polymer compound A/surfactant in the mixed aqueous solution (coating solution for a protective layer) was 4.7/2.8/67.4/18.6/2.3/4.2 (% by mass). Further, the coating amount thereof (covering amount after the drying) was 1.2 g/m². In this manner, the upper protective layer was formed on the surface of the lower protective layer, thereby obtaining lithographic printing plate precursors of Examples 1 to 25 and Comparative Examples 1 to 8.

### [Evaluation of lithographic printing plate precursor]

### (1) Evaluation of non-burning printing durability and residual printing stain resistance (printing stain resistance)

The prepared lithographic printing plate precursors were evaluated by exposing 80% tint images having a resolution of 175 lpi under conditions of an output of 8 W, an external surface drum rotation speed of 206 rpm, and a plate surface energy of 100 mJ/cm² using Trendsetter 3244VX (manufactured by Creo Co., Ltd.) equipped with a water-cooling system 40W infrared semiconductor laser. After each protective layer was removed by washing the surface with tap water after the exposure, the development treatment was performed at a development temperature of 30°C and a transport speed (line speed) of 2 m/min using an automatic development machine LP-1310News (manufactured by Fujifilm Corporation). A 1:4 water-diluted solution of DH-N (manufactured by Fujifilm Corporation) was used as a developer, a 1:1.4 water-diluted solution of "FCT-421" (manufactured by Fujifilm Corporation) was used as a development replenisher, and a 1:1 water-diluted solution of "GN-2K" (manufactured by Fujifilm Corporation) was used as a finisher. Here, the printing was performed with the obtained lithographic printing plate while an operation of wiping the ink from the surface of the plate material was repeated using a multi-cleaner (manufactured by Fujifilm Corporation) every time 10000 sheets were printed using a printing press LITHRONE (manufactured by Komori Corporation). As an index of printing durability, relative evaluation of (the number of printed sheets in each example)/(the number of printed sheets in Comparative Example 1) was used. The results are listed in Table 1. Further, the ink stain, as the residual printing stain resistance (before forced aging), in the non-image area was evaluated through visual observation in 10 scores at the time of evaluation of the printing durability. Evaluation of the residual printing stain resistance (after forced aging) was performed on the lithographic printing plate precursors, which were stored under conditions of 45°C and 75%RH for 4 days and on which forced aging was performed, according to the same method as described above. As the score is greater, stain resistance is excellent. An evaluation score of 8 or greater is a practical level and an evaluation score of 6 is an acceptable lower limit. The results are listed in Table 1.

### (2) Evaluation of chemical resistance

Exposure, development, and printing were performed on the prepared lithographic printing plate precursors in the same manner as in the evaluation of the printing durability. At this time, every time 5,000 sheets were printed, a step of wiping the plate surface with a cleaner (MC-E, manufactured by Fujifilm Corporation, multi-cleaner) was performed, and the chemical resistance was evaluated. The printing durability at this time was evaluated as 4 in a case where the printing durability was in a range of 95% and 100% of the number of printing endurable sheets described above, evaluated as 3 in a case where the printing durability was 80% or greater and less than 95% of the number of printing endurable sheets described above, evaluated as 2 in a case where the printing durability was 60% or greater and less than 80% of the number of printing endurable sheets described above, and evaluated as 1 in a case where the printing durability was less than 60% of the number of printing endurable sheets described above. Even in a case where the step of wiping the plate surface with a cleaner was performed, the chemical resistance was evaluated to be excellent as the change in number of printing endurable sheets was smaller. The results are listed in Table 1.

### (3) Evaluation of residual color

The prepared lithographic printing plate precursor was packed in an RH environment of a temperature of 25°C at a relative humidity of 65% and stored at 70°C for 72 hours, and exposure, development, and printing were performed thereon in the same manner as in the evaluation of the printing durability. The cyan density of the non-image area was measured using a Macbeth reflection densitometer RD-918 and a red filter mounted on the densitometer, and the change between the plate before aging and the plate after aging was observed.

The residual color was evaluated based on the degree of the change in density between before and after aging in conformity with the following scales.
5: A difference in density was less than 0.01.
4: A difference in density was 0.01 or greater and less than 0.03.
3: A difference in density was 0.03 or greater and less than 0.05.
2: A difference in density was 0.05 or greater and less than 0.08.
1: A difference in density was 0.08 or greater.

The evaluation results are collectively listed in Table 1.

**[Table 1]**

| | Type of polymer | Amount of polymer to be added | Amount of binder polymer B (B-1) to be added | Amount of binder polymer C (C-1) to be added | Type of polymerization initiator B | Evaluation results | | | | |
|---|---|---|---|---|---|---|---|---|---|---|
| | | | | | | Printing durability | Printing stain resistance | | Residual color | Chemical resistance |
| | | | | | | | Before forced aging | After forced aging | | |
| Example 1 | PA-1 | 0.623 parts | -- | -- | I-1 | 135 | 9 | 9 | 5 | 4 |
| Example 2 | PA-2 | 0.623 parts | -- | -- | I-1 | 135 | 9 | 9 | 5 | 4 |
| Example 3 | PA-3 | 0.623 parts | -- | -- | I-1 | 140 | 10 | 9 | 5 | 4 |
| Example 4 | PA-4 | 0.623 parts | -- | -- | I-1 | 130 | 10 | 10 | 5 | 4 |
| Example 5 | PA-5 | 0.623 parts | -- | -- | I-1 | 135 | 10 | 10 | 5 | 4 |
| Example 6 | PA-6 | 0.623 parts | -- | -- | I-1 | 135 | 10 | 10 | 5 | 4 |
| Example 7 | PA-3 | 0.311 parts | 0.250 parts | 0.062 parts | I-1 | 130 | 10 | 9 | 4 | 3 |
| Example 8 | PA-3 | 0.373 parts | 0.250 parts | -- | I-1 | 125 | 10 | 10 | 4 | 4 |
| Example 9 | PA-3 | 0.561 parts | -- | 0.062 parts | I-1 | 125 | 9 | 9 | 5 | 4 |
| Example 10 | PA-7 | 0.623 parts | -- | -- | I-1 | 130 | 10 | 10 | 4 | 4 |
| Example 11 | PA-8 | 0.623 parts | -- | -- | I-1 | 130 | 10 | 10 | 5 | 3 |
| Example 12 | PA-9 | 0.623 parts | -- | -- | I-1 | 135 | 10 | 10 | 5 | 4 |
| Example 13 | PA-10 | 0.623 parts | -- | -- | I-1 | 135 | 10 | 10 | 5 | 4 |
| Example 14 | PA-11 | 0.623 parts | -- | -- | I-1 | 140 | 9 | 9 | 5 | 4 |
| Example 15 | PA-12 | 0.623 parts | -- | -- | I-1 | 135 | 10 | 9 | 5 | 4 |
| Example 16 | PA-13 | 0.623 parts | -- | -- | I-1 | 135 | 10 | 10 | 5 | 4 |
| Example 17 | PA-14 | 0.623 parts | -- | -- | I-1 | 130 | 10 | 10 | 5 | 3 |
| Example 18 | PA-15 | 0.623 parts | -- | -- | I-1 | 135 | 10 | 9 | 5 | 4 |
| Example 19 | PA-16 | 0.623 parts | -- | -- | I-1 | 135 | 10 | 10 | 5 | 4 |
| Example 20 | PA-17 | 0.623 parts | -- | -- | I-1 | 140 | 10 | 10 | 4 | 4 |
| Example 21 | PA-18 | 0.623 parts | -- | -- | I-1 | 135 | 10 | 9 | 5 | 4 |
| Example 22 | PA-19 | 0.623 parts | -- | -- | I-1 | 140 | 9 | 9 | 5 | 4 |
| Example 23 | PA-3 | 0.623 parts | -- | -- | I-2 | 135 | 10 | 10 | 5 | 4 |
| Example 24 | PA-5 | 0.623 parts | -- | -- | I-2 | 135 | 10 | 10 | 5 | 4 |
| Example 25 | PA-6 | 0.623 parts | -- | -- | I-2 | 130 | 10 | 10 | 5 | 4 |
| Comparative Example 1 | R-1 | 0.311 parts | 0.250 parts | 0.062 parts | I-1 | 100 | 7 | 6 | 3 | 2 |
| Comparative Example 2 | R-1 | 0.373 parts | 0.250 parts | -- | I-1 | 80 | 7 | 6 | 2 | 2 |
| Comparative Example 3 | R-1 | 0.561 parts | -- | 0.062 parts | I-1 | 90 | 6 | 5 | 2 | 2 |
| Comparative Example 4 | R-1 | 0.623 parts | -- | -- | I-1 | 85 | 7 | 6 | 2 | 1 |
| Comparative Example 5 | R-2 | 0.623 parts | -- | -- | I-1 | 110 | 7 | 7 | 4 | 3 |
| Comparative Example 6 | R-3 | 0.623 parts | -- | -- | I-1 | 85 | 4 | 3 | 2 | 3 |
| Comparative Example 7 | R-4 | 0.623 parts | -- | -- | I-1 | 105 | 4 | 4 | 4 | 1 |
| Comparative Example 8 | R-5 | 0.623 parts | -- | -- | I-1 | 95 | 4 | 3 | 2 | 1 |

Further, R-1 to R-5 listed in Table 1 indicate the following resins.

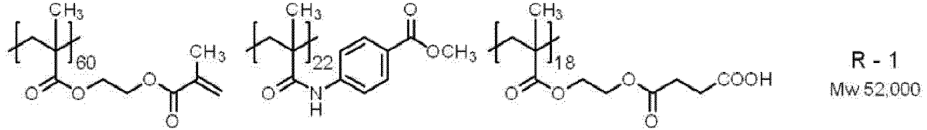

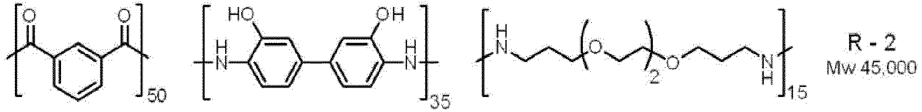

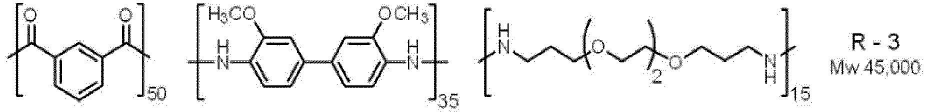

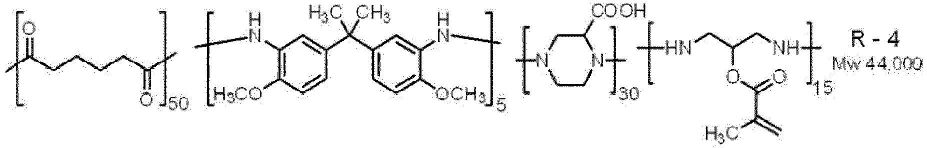

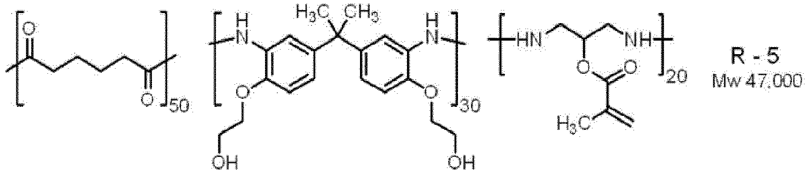

The disclosure of JP No. 2016-010620 filed on January 22, 2016 is incorporated in the present specification by reference.

All documents, patent applications, and technical standards described in the present specification are incorporated herein by reference to the same extent as a case of being specifically and individually noted that individual documents, patent applications, and technical standards are incorporated by reference.

## Claims

1. A negative type lithographic printing plate precursor comprising:
a support having a hydrophilic surface; and
an image recording layer, on the support, containing a polymerization initiator and a polymer compound having a structure represented by Formula 1 in a main chain and an ethylenically unsaturated bond, 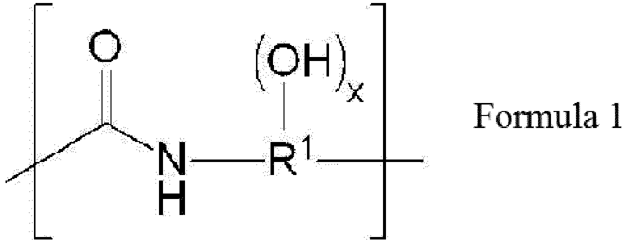 wherein, in Formula 1, R¹ represents an (x + 2)-valent aromatic hydrocarbon ring group, and x represents an integer of 1 to 4.

2. The negative type lithographic printing plate precursor according to claim 1,
wherein the polymer compound is a polymer compound having a structure represented by Formula 2 in a main chain, 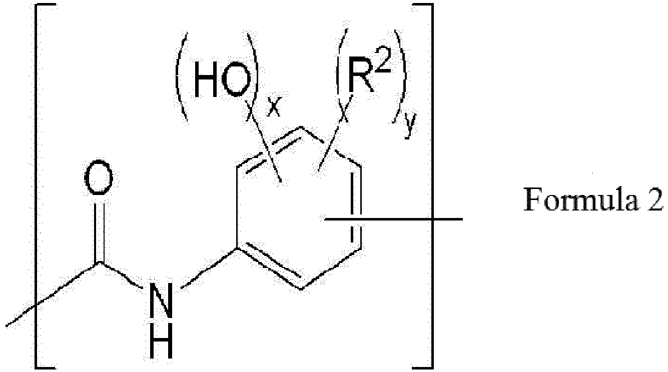 in Formula 2, R²'s each independently represent an alkyl group or an aryl group, x represents an integer of 1 to 4, and y represents an integer of 0 to 3.

3. The negative type lithographic printing plate precursor according to claim 1 or 2,
wherein the polymer compound is a polymer compound having a structure represented by Formula 3, 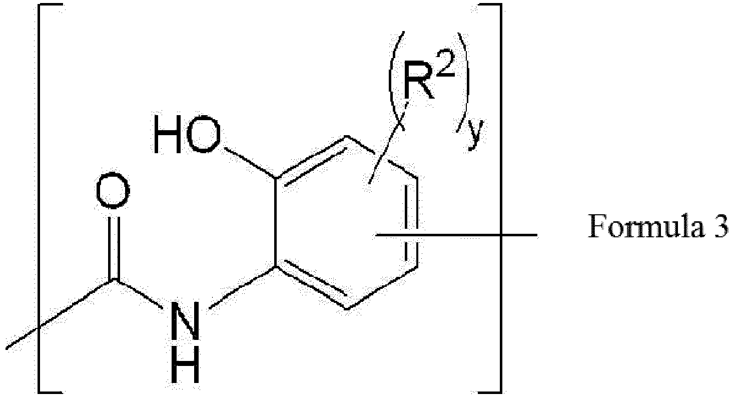 in Formula 3, R²'s each independently represent an alkyl group or an aryl group, and y represents an integer of 0 to 3.

4. The negative type lithographic printing plate precursor according to claim 1,
wherein an amide bond in Formula 1 is not a part of a urea bond.

5. The negative type lithographic printing plate precursor according to any one of claims 1 to 4,
wherein the polymer compound is a resin having a constitutional repeating unit represented by Formula 4, 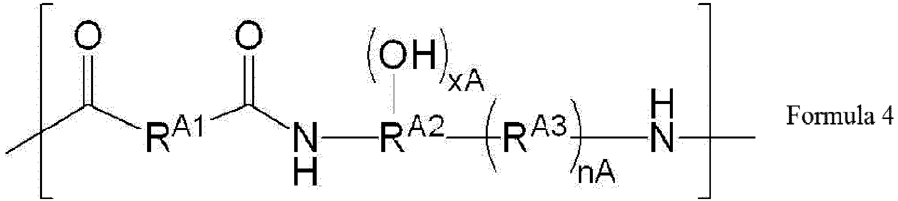 in Formula 4, R^{A1} represents a divalent linking group, R^{A2} represents an (xA + 2)-valent aromatic hydrocarbon ring group, R^{A3} represents a divalent linking group, xA represents an integer of 1 to 4, and nA represents 0 or 1.

6. The negative type lithographic printing plate precursor according to claim 5,
wherein R^{A1} represents a divalent linking group bonded to two carbonyl groups in Formula 4 through a carbon atom.

7. The negative type lithographic printing plate precursor according to any one of claims 1 to 6,
wherein the image recording layer further contains a sensitizing dye having a maximum absorption wavelength of 700 to 1300 nm.

8. The negative type lithographic printing plate precursor according to any one of claims 1 to 6,
wherein the image recording layer further contains a sensitizing dye having a maximum absorption wavelength of 300 to 600 nm.

9. The negative type lithographic printing plate precursor according to any one of claims 1 to 8,
wherein the image recording layer further contains a polymerizable compound.

10. The negative type lithographic printing plate precursor according to any one of claims 1 to 9,
wherein the polymer compound is a polyamide resin.

11. The negative type lithographic printing plate precursor according to any one of claims 1 to 10,
wherein the polymerization initiator is a photo-radical polymerization initiator.

12. The negative type lithographic printing plate precursor according to any one of claims 1 to 11,
wherein the polymerization initiator is an onium salt compound.

13. The negative type lithographic printing plate precursor according to any one of claims 1 to 12, further comprising an undercoat layer between the support and the image recording layer.

14. The negative type lithographic printing plate precursor according to any one of claims 1 to 13, further comprising a protective layer on the image recording layer.

15. A method of preparing a lithographic printing plate, comprising, in order:
an exposure step of image-exposing the negative type lithographic printing plate precursor according to any one of claims 1 to 14; and
a development step of performing development by removing a non-exposed portion of the exposed negative type lithographic printing plate precursor using a developer.
